# EUROPEAN PATENT APPLICATION

(11) **EP 4 597 501 A1**
(43) Date of publication of application: **06.08.2025**
(21) Application number: 22960833.6
(22) Date of filing: 27.09.2022
(51) Int. Cl.: G11C 11/54, G06G 7/60, G06N 3/063, G11C 11/412

(54) **COMPUTATION DEVICE, IMAGING DEVICE AND COMPUTATION METHOD**

(71) Applicant: Sony Semiconductor Solutions Corporation, Atsugi-shi, Kanagawa 243-0014 (JP)
(72) Inventor: SAITO Daisuke, Atsugi-shi, Kanagawa 243-0014 (JP); HANZAWA Katsuhiko, Atsugi-shi, Kanagawa 243-0014 (JP); SAKAKIBARA Masaki, Atsugi-shi, Kanagawa 243-0014 (JP); MAEDA Noriaki, Atsugi-shi, Kanagawa 243-0014 (JP); NAGANUMA Hideki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/036010
(87) International publication number: WO 2024/069769

(57) **Abstract**

The present disclosure provides an arithmetic device including: a first signal line; a first capacitance connected to the first signal line; at least one subarray connected to the first signal line; and a readout circuit that generates a digital signal according to a charge of the first signal line. The subarray includes: a second signal line connected to the first signal line via a first switching element; a second capacitance connected to the second signal line; and at least one memory cell connected to the second signal line and capable of supplying a charge corresponding to a signal value to be stored to the second signal line.

## Description

### [Technical Field]

This disclosure relates to an arithmetic device, an imaging device, and a computing method.

### [Background Art]

In recent years, processors that implement deep neural networks (DNNs) in hardware to perform computations have been put into practical use in order to realize advanced tasks such as image recognition and object position detection. However, since neural networks (DNNs) require a lot of memory access, the power efficiency of von Neumann-type arithmetic units (for example, DSPs) is poor. For this reason, CIM (Computing in memory), which is a non-von Neumann-type arithmetic unit which performs computations on a memory array, has attracted attention as a computing method for DNNs.

### [Citation List]

### [Patent Literature]

[PTL 1] Japanese Patent Application No. 2021-510774
[PTL 2] JP 2020-113809A

### [Summary]

### [Technical Problem]

Therefore, the present disclosure provides an arithmetic device, an imaging device, and a computing method capable of performing computations on a memory array at higher speeds.

### [Solution to Problem]

In order to solve the above problems, the present disclosure provides an arithmetic device including: a first signal line; a first capacitance connected to the first signal line; at least one subarray connected to the first signal line; and a readout circuit that generates a digital signal according to a charge of the first signal line, wherein the subarray includes: a second signal line connected to the first signal line via a first switching element; a second capacitance connected to the second signal line; and at least one memory cell connected to the second signal line and capable of supplying a charge corresponding to a signal value to be stored to the second signal line.

The first capacitance and the second capacitance may be parasitic capacitances formed in a metal layer of a semiconductor element.

A plurality of the subarrays may be connected to the first signal line, and the second capacitance may be different for each subarray.

A plurality of the subarrays may be connected to the first signal line, and the second capacitance may be a variable capacitance.

The memory cell may be connected to the second signal line via a second switching element to supply the charge corresponding to the signal value to the second signal line.

The second switching element may be configured by a single switching element or by connecting a plurality of switching elements in series, one end of the second switching element may be connected to the second signal line, the second switching element may be turned on or off depending on the stored data, a potential pulse signal may be supplied from the other end of the second switching element, and a charge corresponding to a potential and a pulse width of the potential pulse signal may be stored in the second capacitance.

The subarray may have a plurality of the memory cells, and the memory cells may be static random access memories (SRAMs) having the second switching elements.

The arithmetic device may have: a mode in which the second signal line and the plurality of memory cells are sequentially turned on at different timings, a mode in which the second signal line and the plurality of memory cells are simultaneously turned on, and a mode in which the second signal line and the plurality of memory cells are repeatedly turned on at different timings.

When the plurality of subarrays are used as memories, the variable capacitances of each of the plurality of the subarrays may have the same capacitance, and when the subarrays are used as arithmetic units, the variable capacitances of each of the plurality of the subarrays may be changeable according to a rate of data addition.

Among the plurality of subarrays, a subarray to be used as an arithmetic unit and a subarray to be used as a memory may be switchable.

The arithmetic device may further include: a first control unit that controls the first switching element and the second switching element; and a second control unit that controls a potential of the second signal line when data is written to the memory cell.

The subarray may have a plurality of the memory cells, and the memory cell may be composed of the second switching element and a flip-flop.

The second signal line may be connected to the first signal line via the first switching element and a first resistor.

The memory cell may be connected to the second signal line via the second switching element and a second resistor.

Either the first switching element or the second switching element may have a predetermined resistance value.

The arithmetic device may further include: a first control unit that controls the first switching element and the second switching element, a second control unit that controls a potential of the second signal line when data is written to the memory cell; and an array unit, wherein the array unit may have a plurality of subarray units arranged in a matrix, the subarray unit may have a plurality of subarrays connected in a column to the first signal line, the first control unit may be arranged at both ends of one of the array units, and the second control unit may be arranged at both ends of the other of the array units.

The subarray units may share the readout circuit.

The arithmetic device may include a plurality of the readout circuits, and at least one of the plurality of readout circuits may be arranged at one end of the array unit, and at least one of the plurality of readout circuits may be arranged at the other end of the array unit.

In order to solve the above problem, the present disclosure provides an arithmetic device and a pixel array unit in which pixels that generate pixel signals obtained by photoelectrically converting incident light are arranged two-dimensionally, wherein image data obtained by converting the pixel signals into digital data is stored in the memory cells of the arithmetic device.

To solve the above problem, the present disclosure provides a computing method for an arithmetic device including a plurality of second signal lines connected to a first signal line to which a first capacitance is connected; a second capacitance connected to each of the plurality of second signal lines; and a memory cell connected to each of the plurality of second signal lines, the method comprising: supplying a charge corresponding to a signal value to be stored in the memory cell to each of the second signal lines; storing the charge corresponding to the signal value to be stored in the memory cell in each of the second capacitances; capacitively dividing the charge stored between the first capacitance and the plurality of second capacitances; and obtaining a digital signal corresponding to the charge of the first signal line.

Aspects of the present disclosure are not limited to the aforementioned individual embodiments and include various modifications that those skilled in the art can achieve, and effects of the present disclosure are also not limited to the details described above. In other words, various additions, modifications, and partial deletion can be made without departing from the conceptual idea and the gist of the present disclosure that can be derived from the details defined in the claims and the equivalents thereof.

### [Brief Description of Drawing]

[Fig. 1]

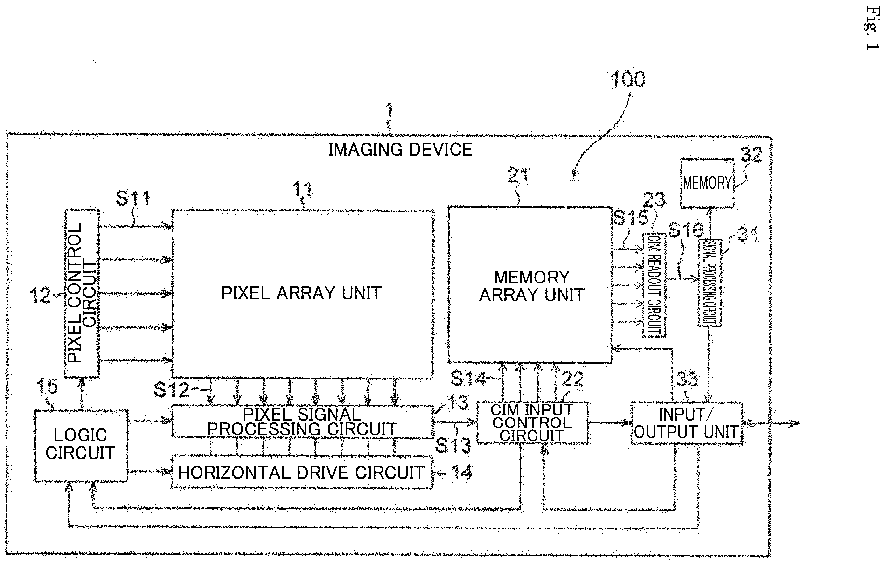

   Fig. 1 is a diagram showing the configuration of an imaging device according to a first embodiment of the present technology.
[Fig. 2]

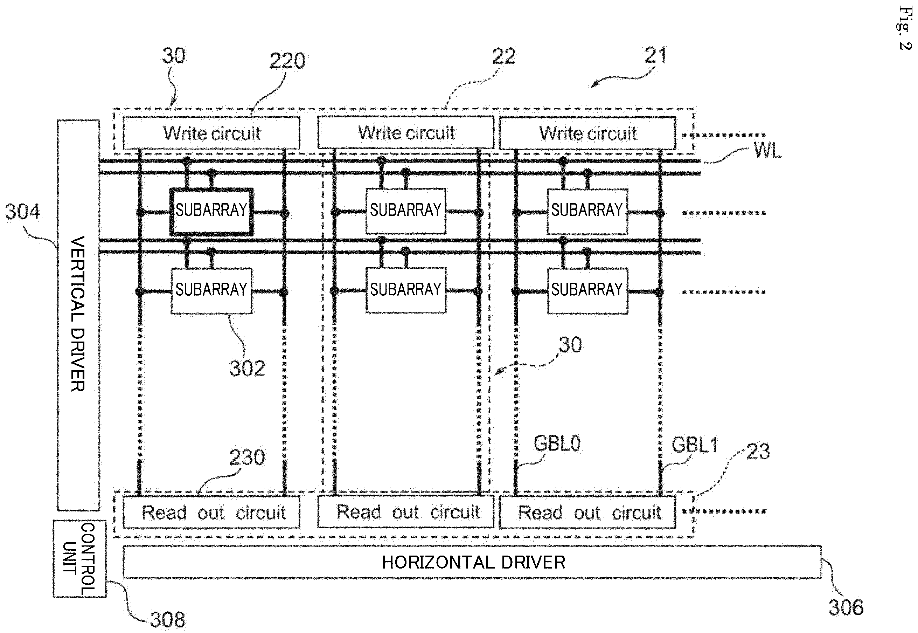

   Fig. 2 is a diagram showing an example of the configuration of a memory array unit.
[Fig. 3]

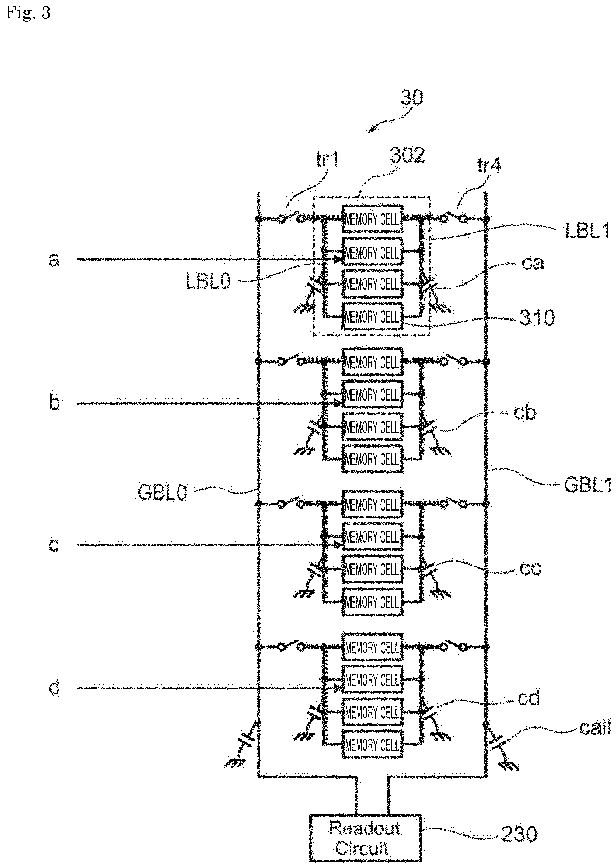

   Fig. 3 is a diagram showing an example of the configuration of a subarray connected between local bit lines.
[Fig. 4]

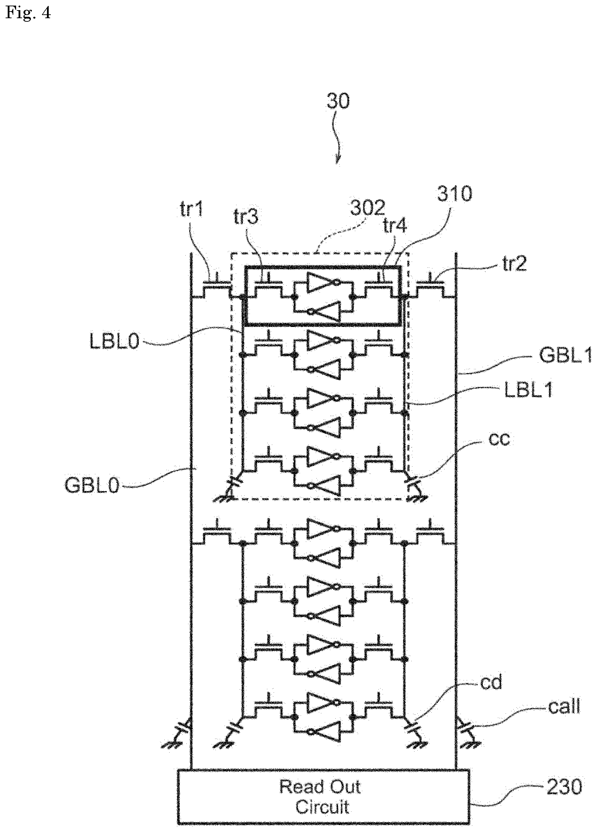

   Fig. 4 is a diagram showing an example of an equivalent circuit of Fig. 3.
[Fig. 5]

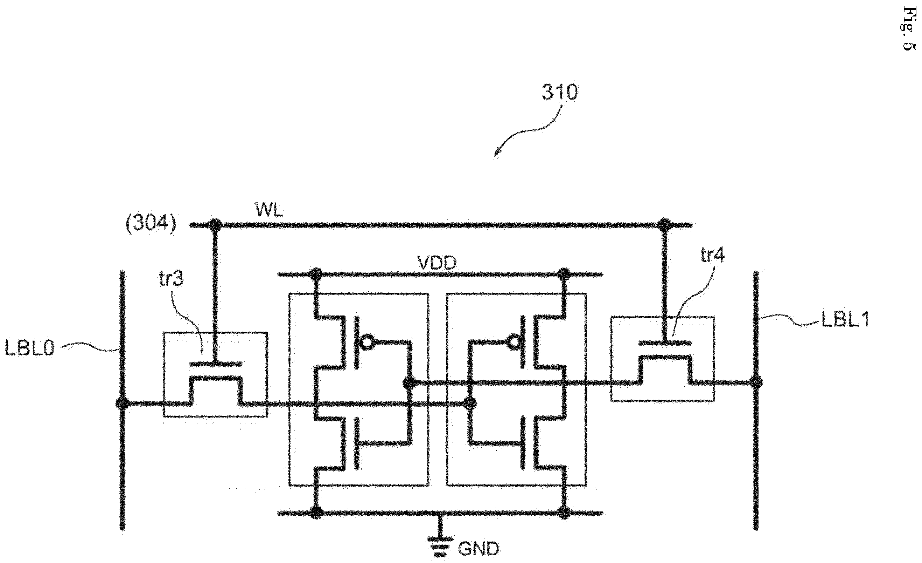

   Fig. 5 is a diagram showing an example of a memory cell configured with a 6-transistor SRAM.
[Fig. 6]

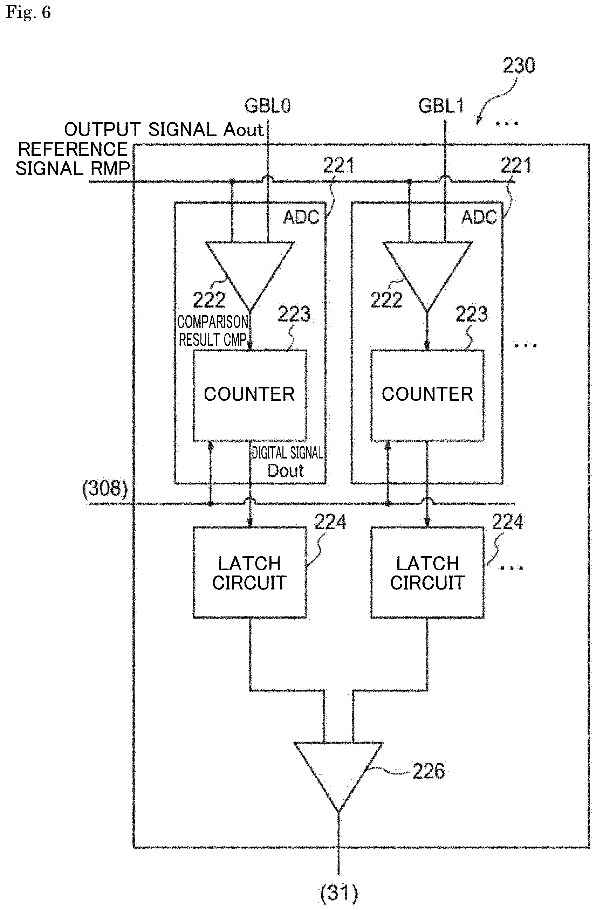

   Fig. 6 is a diagram showing an example of the configuration of a readout circuit.
[Fig. 7]

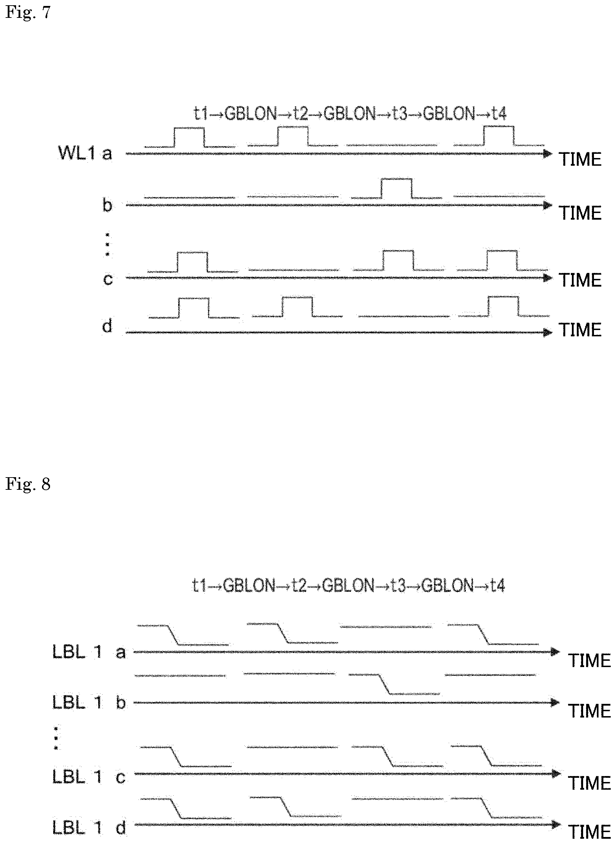

   Fig. 7 is a diagram showing an example of a pulse signal supplied from a vertical driver.
[Fig. 8]
   Fig. 8 is a diagram schematically showing a potential fluctuation of a local bit line.
[Fig. 9]

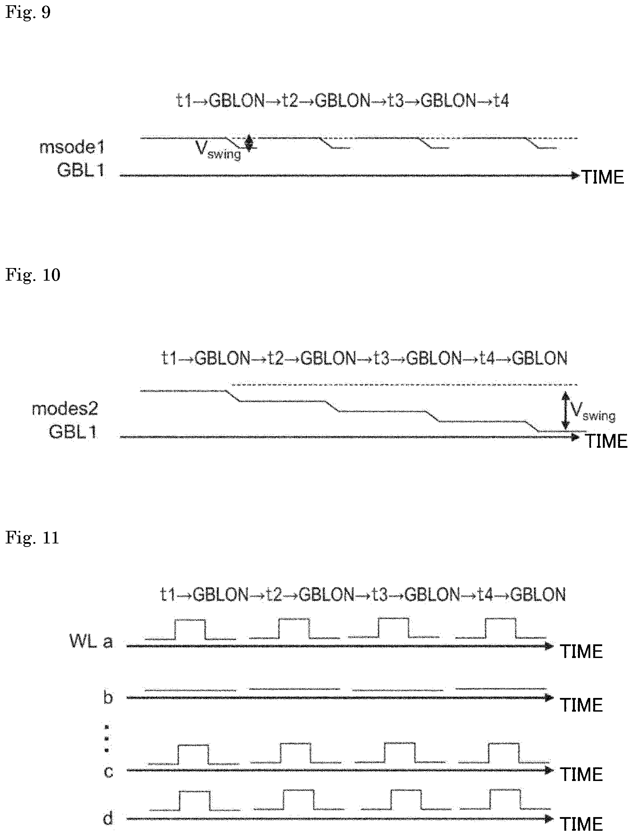

   Fig. 9 is a diagram showing a potential fluctuation of a global line in Mode 1.
[Fig. 10]
   Fig. 10 is a diagram showing a potential fluctuation of a global line in Mode 2.
[Fig. 11]
   Fig. 11 is a diagram showing an example of a pulse signal supplied from a vertical driver to a word line.
[Fig. 12]

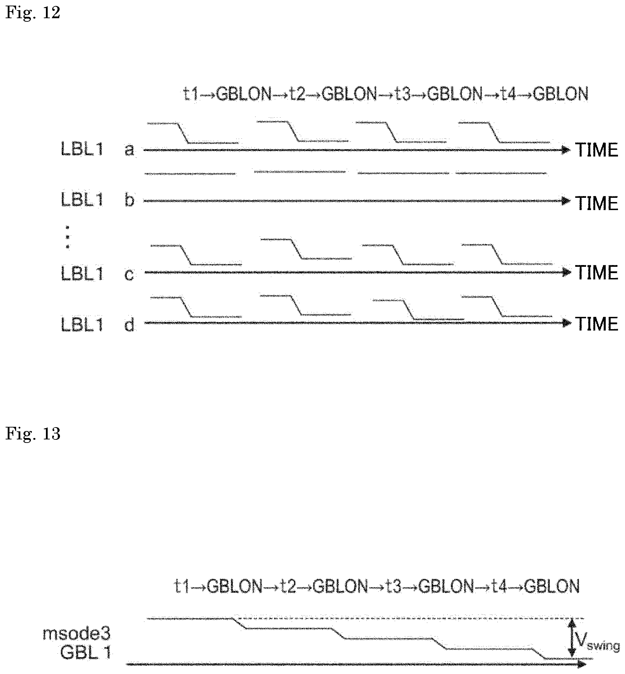

   Fig. 12 is a diagram schematically showing a potential fluctuation of a local bit line.
[Fig. 13]
   Fig. 13 is a diagram showing a potential fluctuation of a global bit line in Mode 3.
[Fig. 14]

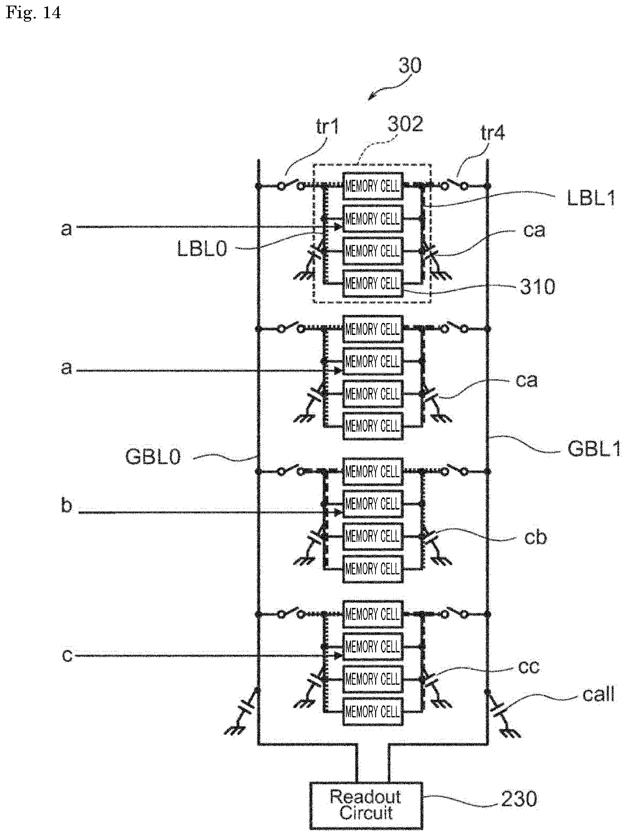

   Fig. 14 is a diagram showing an imaging device according to Modification 1 of the first embodiment.
[Fig. 15]

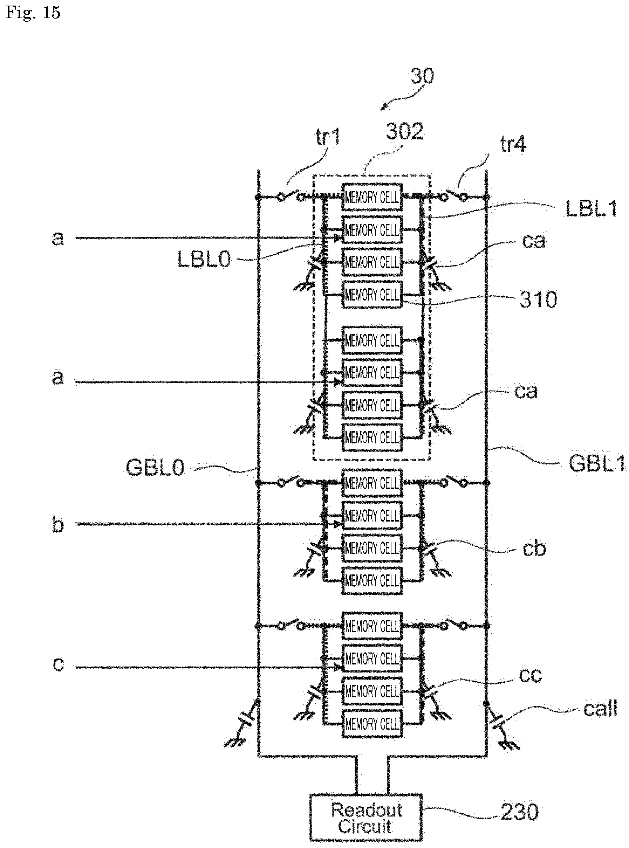

   Fig. 15 is a diagram showing an imaging device according to Modification 2 of the first embodiment.
[Fig. 16]

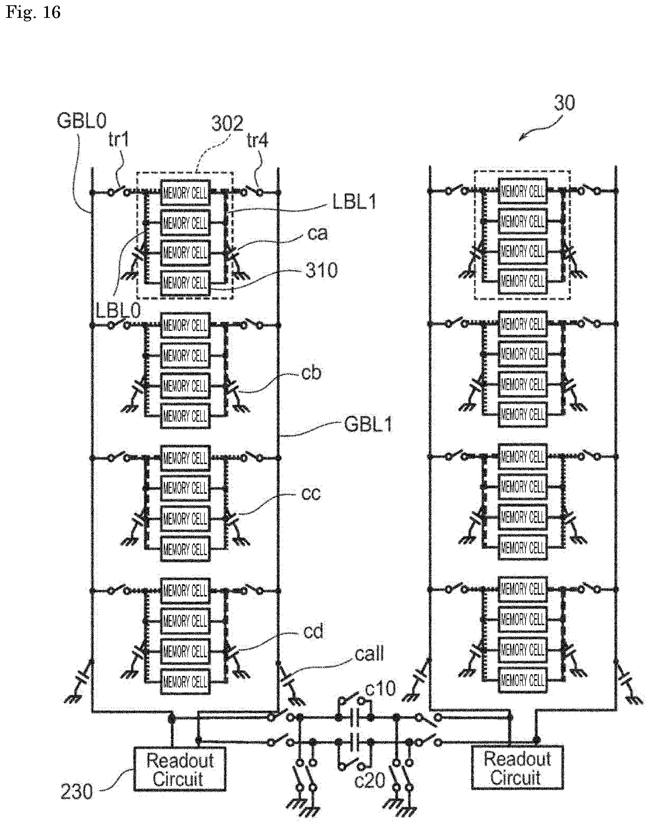

   Fig. 16 is a diagram showing an imaging device according to Modification 3 of the first embodiment.
[Fig. 17]

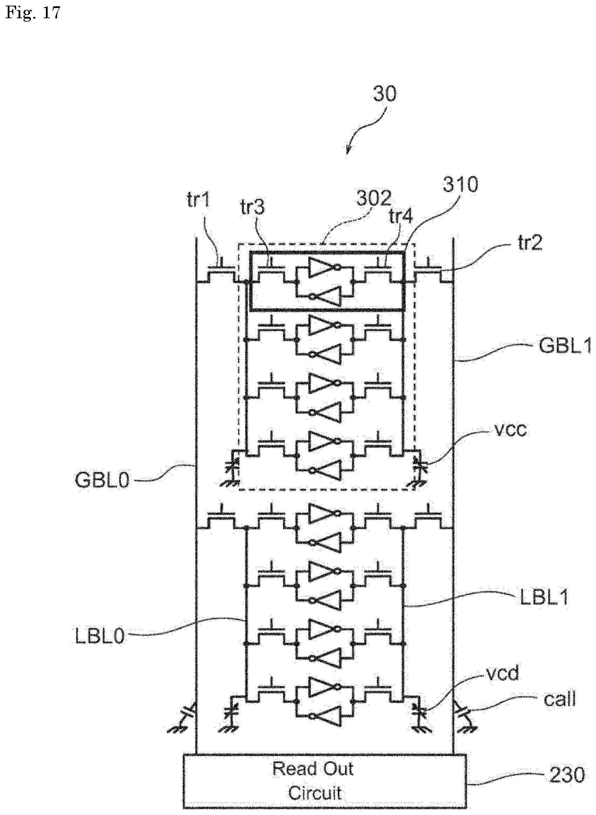

   Fig. 17 is a diagram showing an imaging device according to Modification 4 of the first embodiment.
[Fig. 18A]

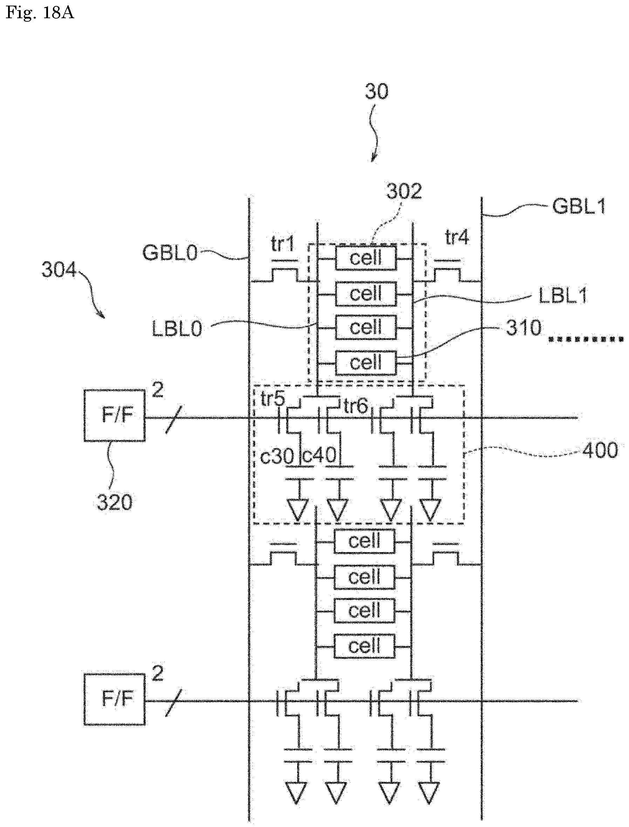

   Fig. 18A is a diagram showing an imaging device according to Modification 5 of the first embodiment.
[Fig. 18B]

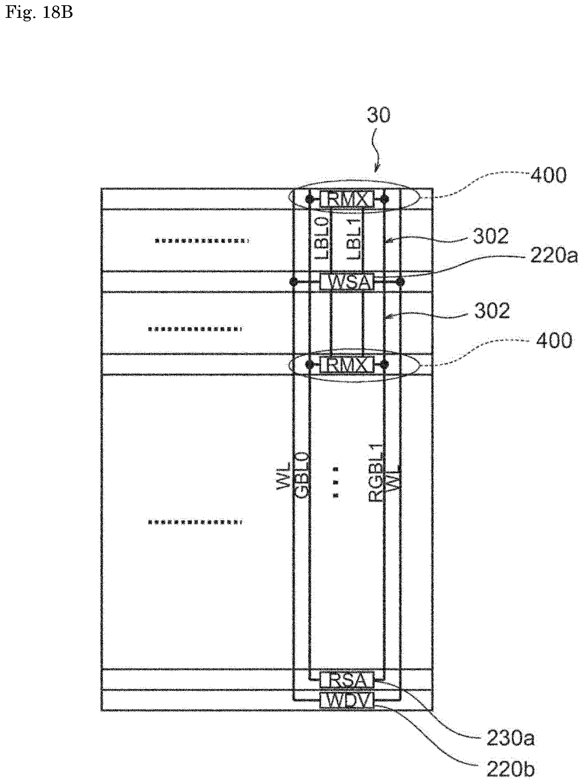

   Fig. 18B is a diagram showing an example of the arrangement of subarrays according to Modification 5 of the first embodiment.
[Fig. 19A]

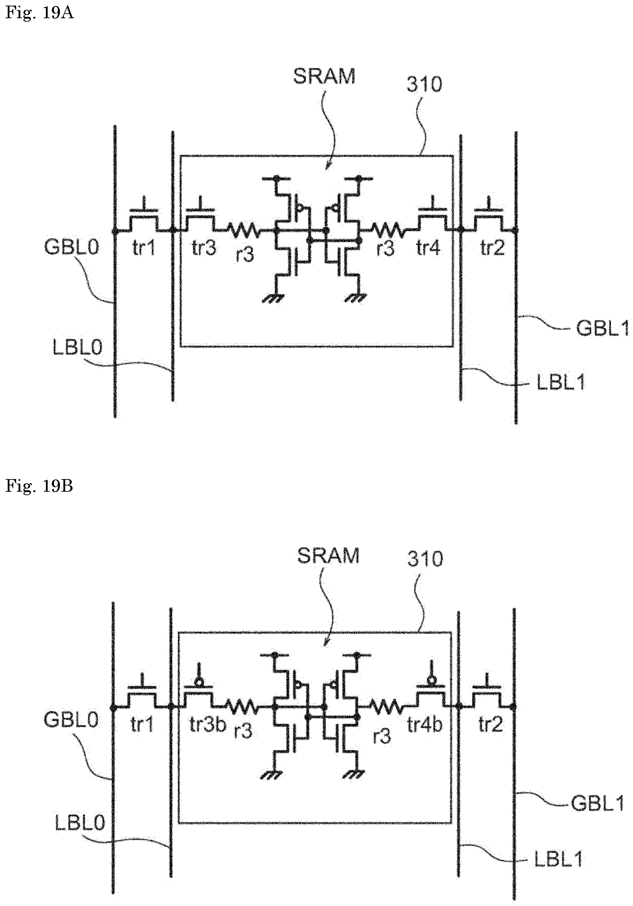

   Fig. 19A is a diagram showing an example of the configuration of a memory cell according to Modification 6 of the first embodiment.
[Fig. 19B]
   Fig. 19B is a diagram showing an example of the configuration of a memory cell according to Modification 7 of the first embodiment.
[Fig. 19C]

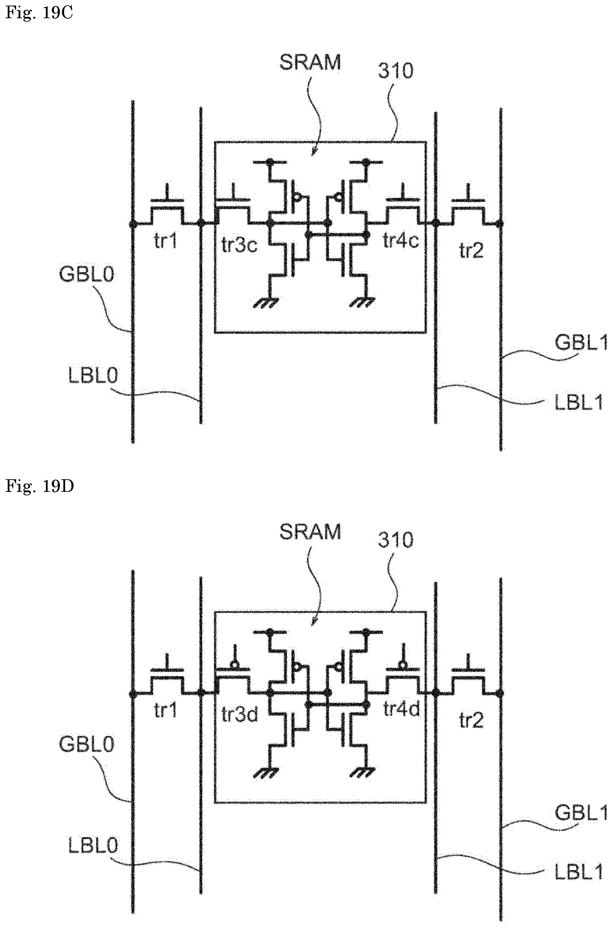

   Fig. 19C is a diagram showing an example of the configuration of a memory cell according to Modification 8 of the first embodiment.
[Fig. 19D]
   Fig. 19D is a diagram showing an example of the configuration of a memory cell according to Modification 9 of the first embodiment.
[Fig. 20]

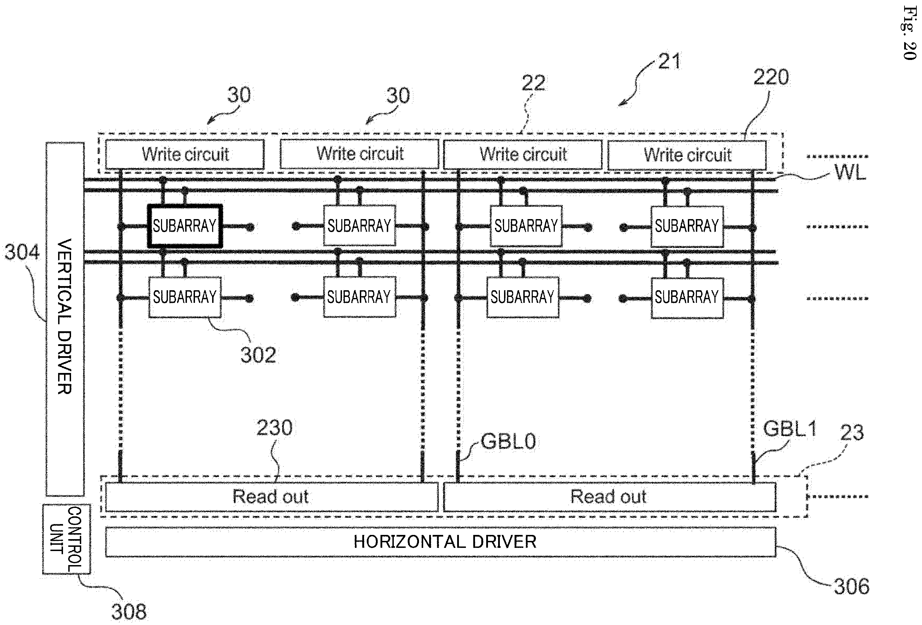

   Fig. 20 is a diagram showing an example of the configuration of a memory array unit according to a second embodiment.
[Fig. 21]

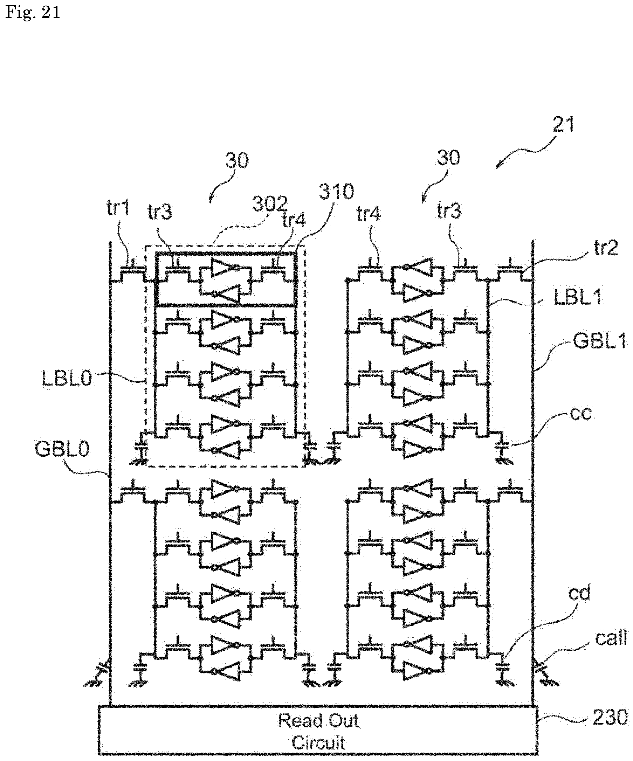

   Fig. 21 is a diagram showing a more detailed example of the configuration of the memory array unit.
[Fig. 22]

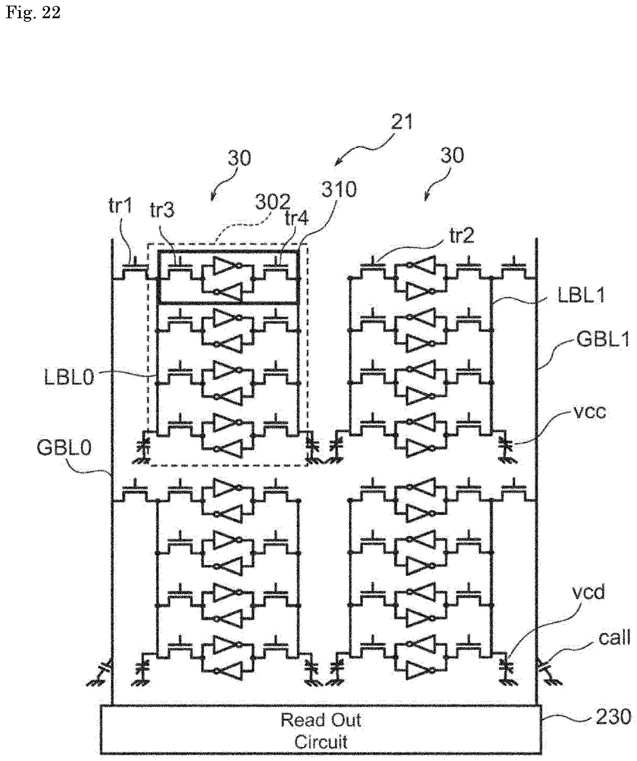

   Fig. 22 is a block diagram showing an imaging device according to Modification 1 of the second embodiment.
[Fig. 23]

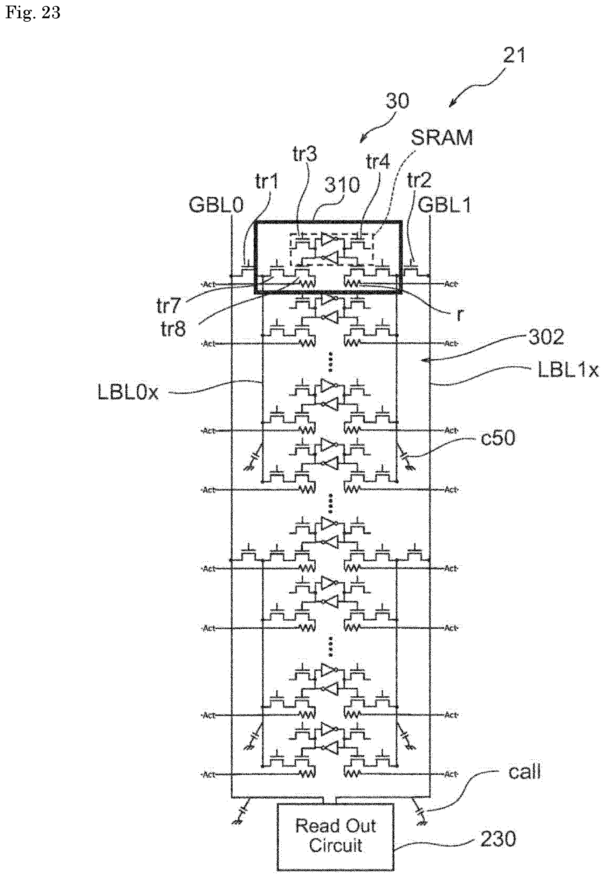

   Fig. 23 is a block diagram showing an example of the configuration of a memory array unit according to a third embodiment.
[Fig. 24]

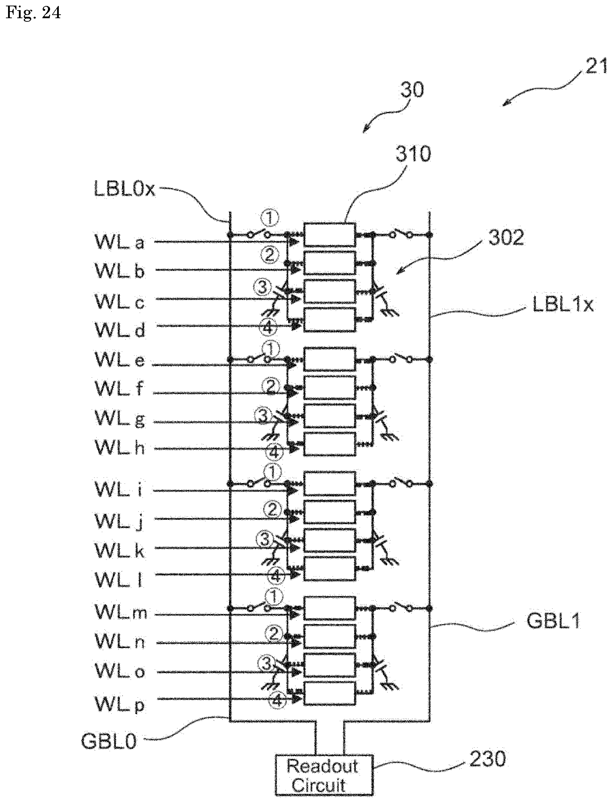

   Fig. 24 is a block diagram showing a word line having the same configuration as that of Fig. 23.
[Fig. 25]

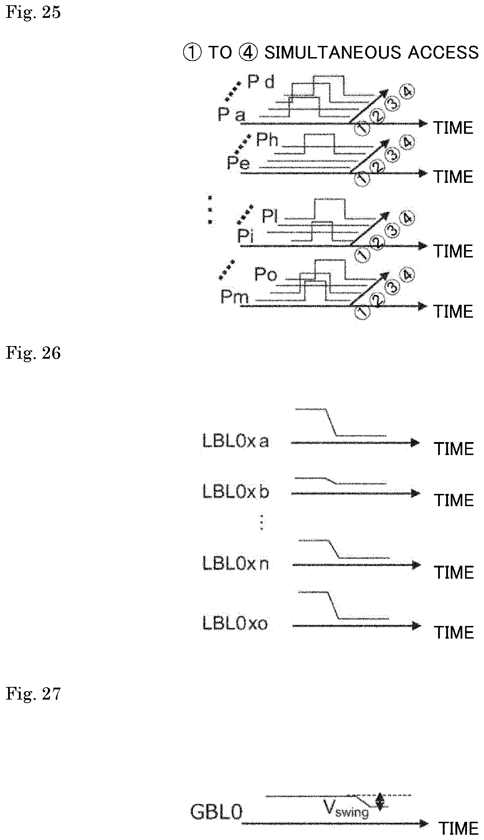

   Fig. 25 is a diagram showing an example of a pulse signal supplied from a vertical driver to a word line.
[Fig. 26]
   Fig. 26 is a diagram showing the amount of potential fluctuation of a pulse signal applied to a local bit line.
[Fig. 27]
   Fig. 27 is a diagram showing potential fluctuation of a global line.
[Fig. 28]

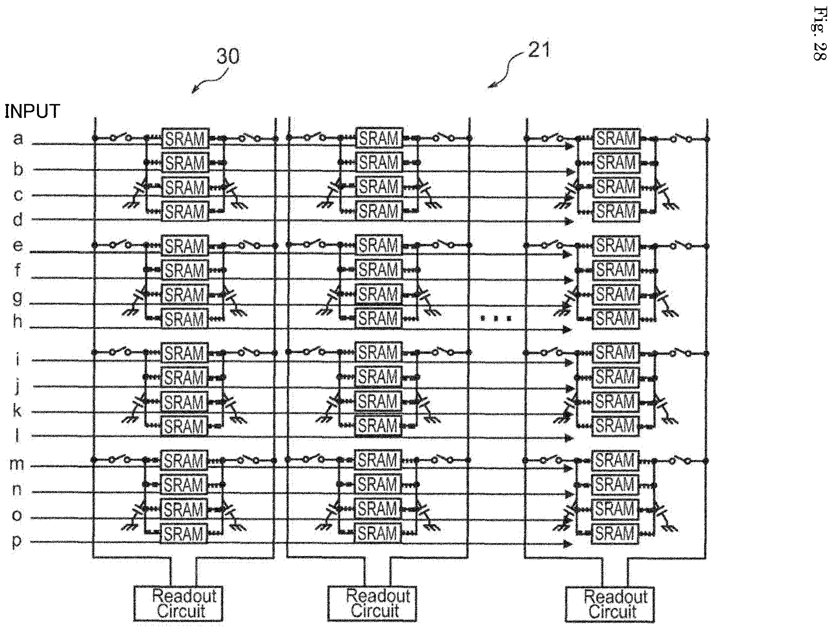

   Fig. 28 is a diagram showing an example in which different pulse signals are simultaneously applied to each subarray for each column.
[Fig. 29]

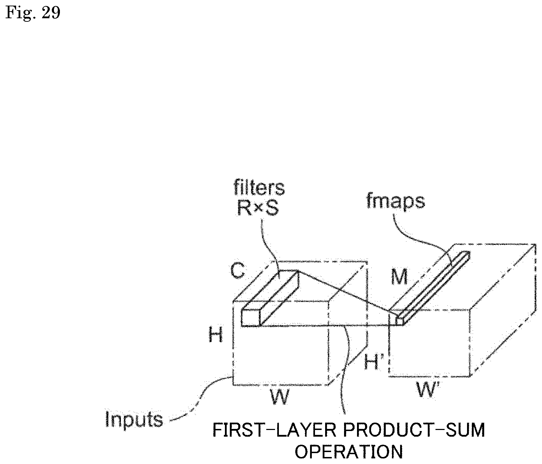

   Fig. 29 is a diagram showing a pixel value of a captured image and a calculation value of a convolution operation.
[Fig. 30]

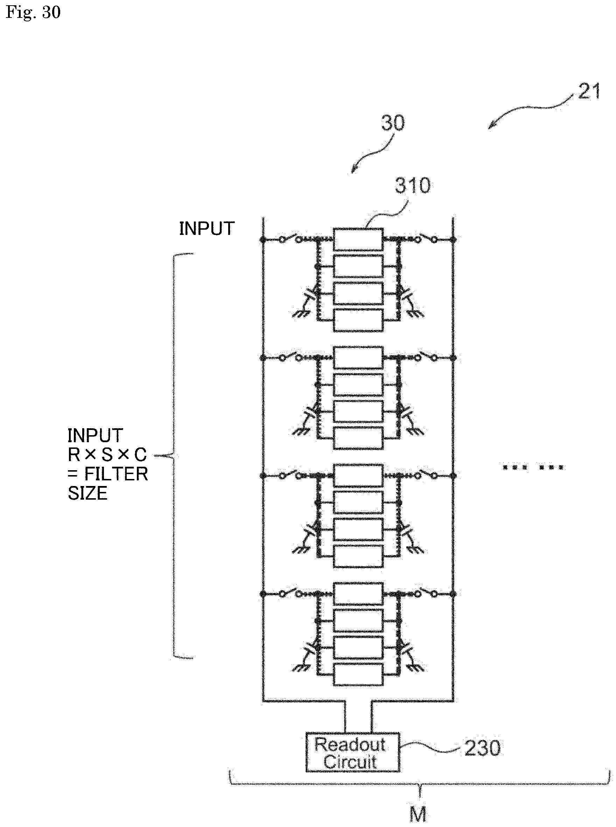

   Fig. 30 is a diagram showing an example of the configuration of a memory array unit when the operation of Fig. 29 is performed.
[Fig. 31]

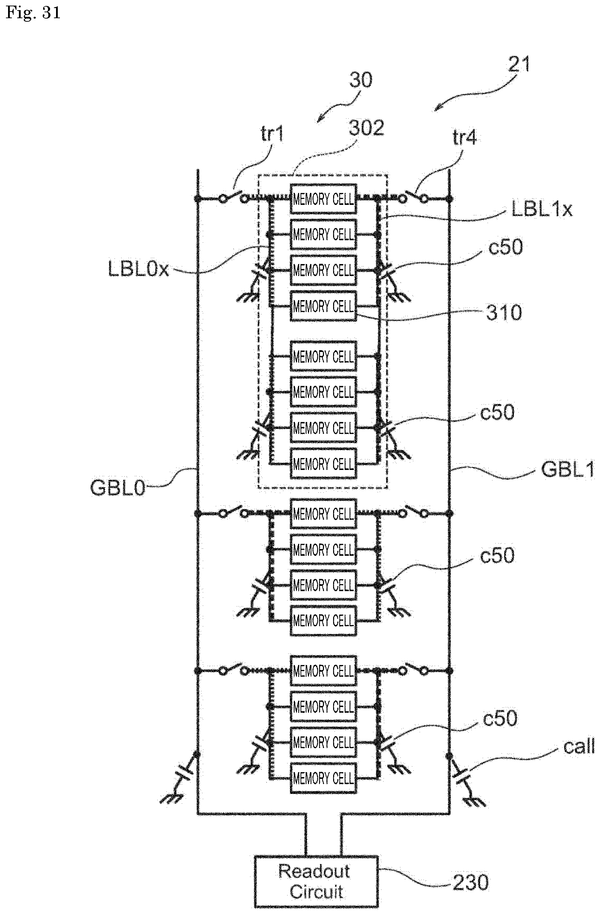

   Fig. 31 is a block diagram showing a subarray according to Modification 1 of the third embodiment.
[Fig. 32]

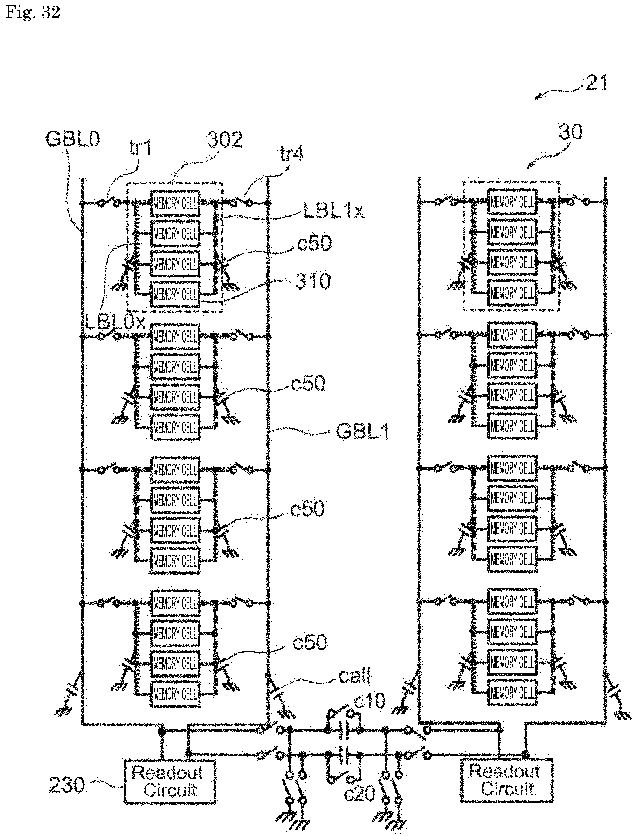

   Fig. 32 is a block diagram showing a subarray according to Modification 2 of the third embodiment.
[Fig. 33]

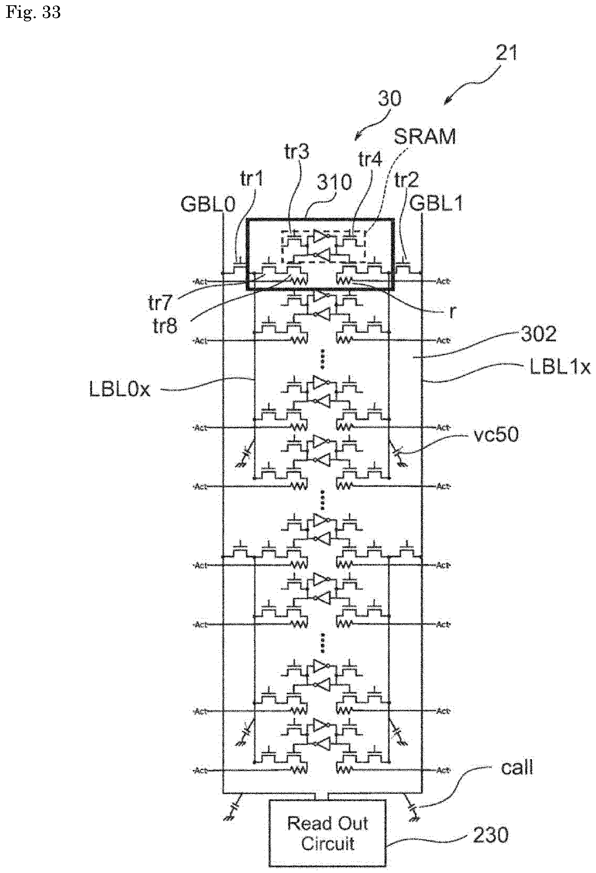

   Fig. 33 is a block diagram showing a subarray according to Modification 3 of the third embodiment.
[Fig. 34]

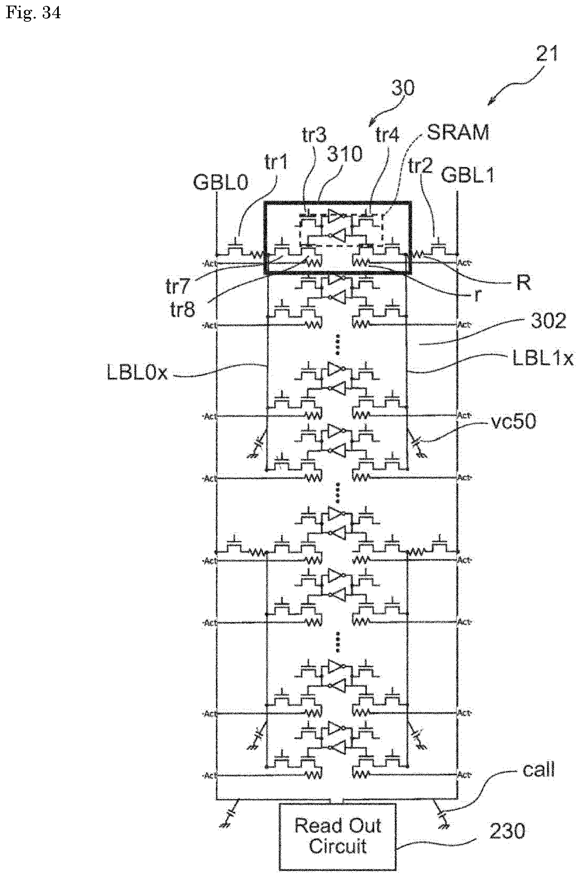

   Fig. 34 is a diagram showing a memory array unit 21 according to Modification 4 of the third embodiment.
[Fig. 35]

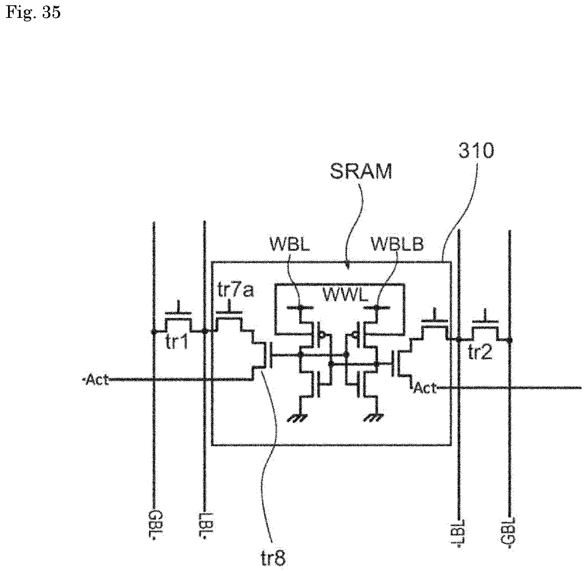

   Fig. 35 is a diagram showing an example of the configuration of a memory cell according to Modification 5 of the third embodiment.
[Fig. 36]

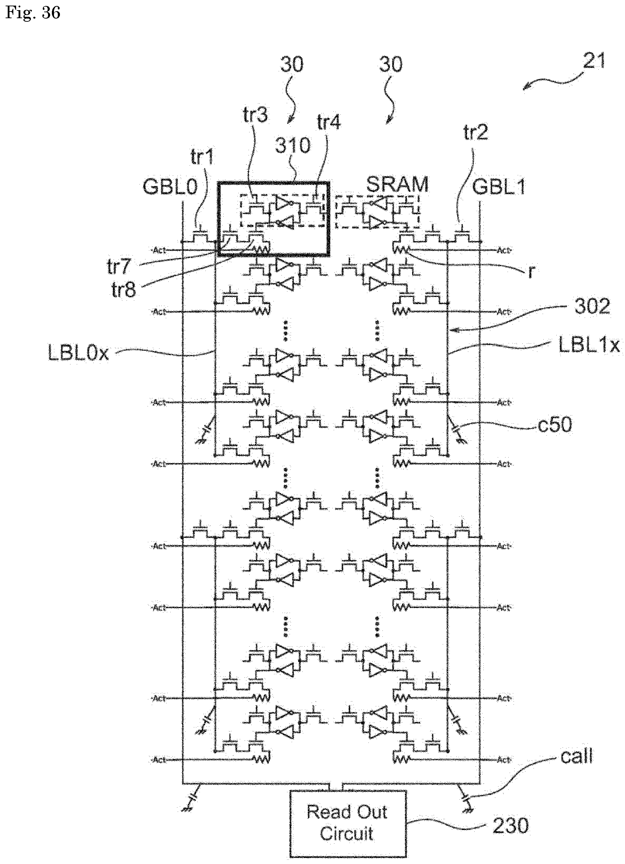

   Fig. 36 is a diagram showing an example of the configuration of a memory array unit according to a fourth embodiment.
[Fig. 37]

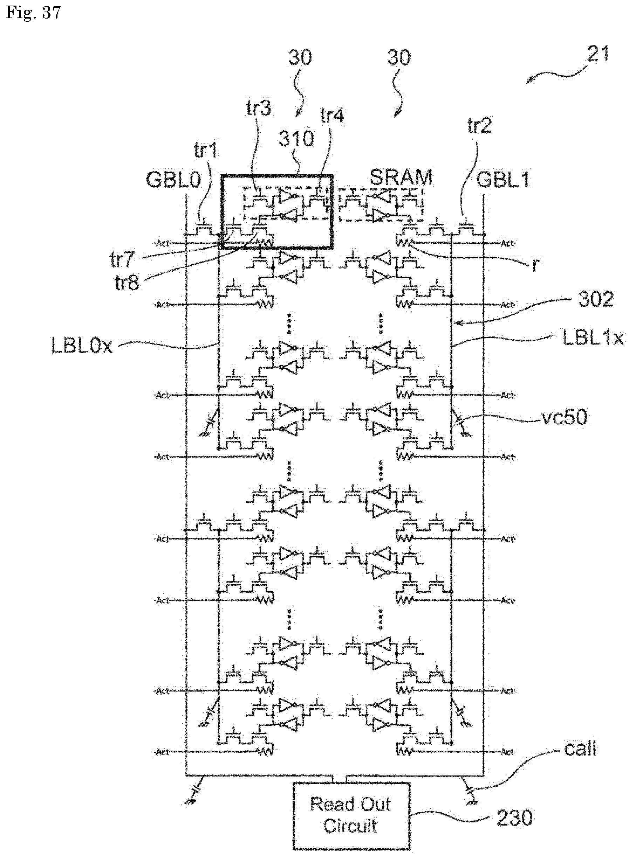

   Fig. 37 is a diagram showing an example of the configuration of a memory array unit according to Modification 1 of the fourth embodiment.
[Fig. 38]

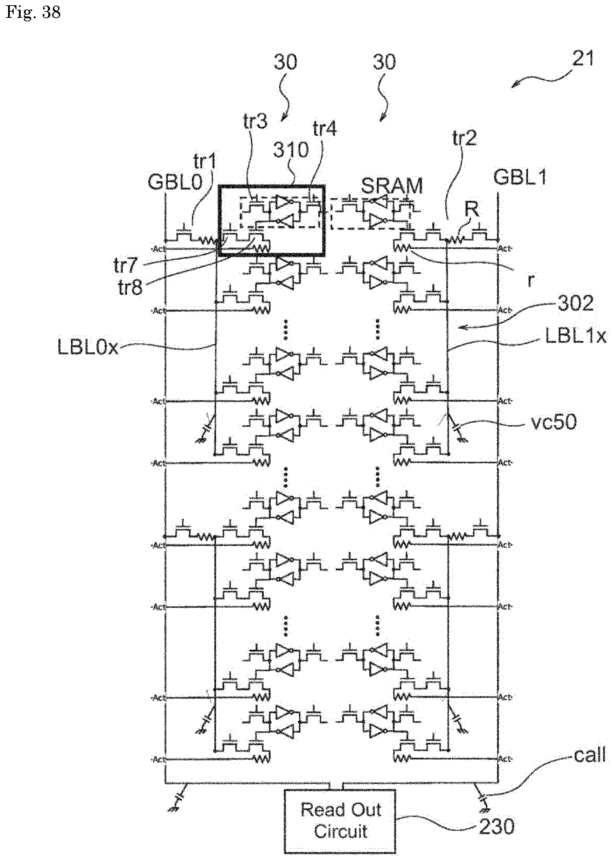

   Fig. 38 is a diagram showing an example of the configuration of a memory array unit according to Modification 2 of the fourth embodiment.
[Fig. 39]

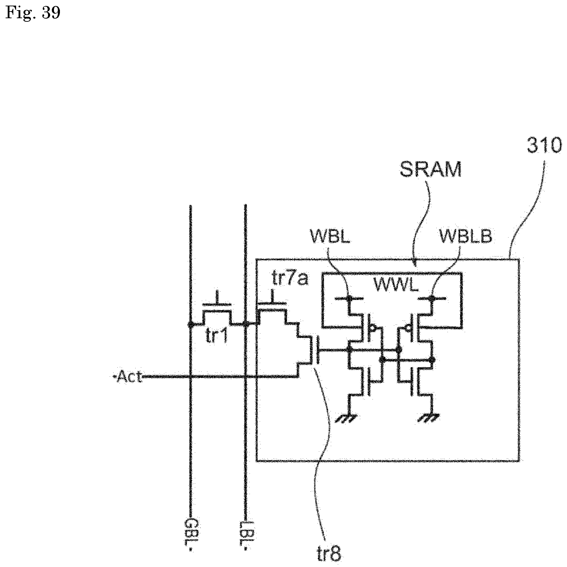

   Fig. 39 is a diagram showing an example of the configuration of a memory cell according to Modification 3 of the fourth embodiment.
[Fig. 40]

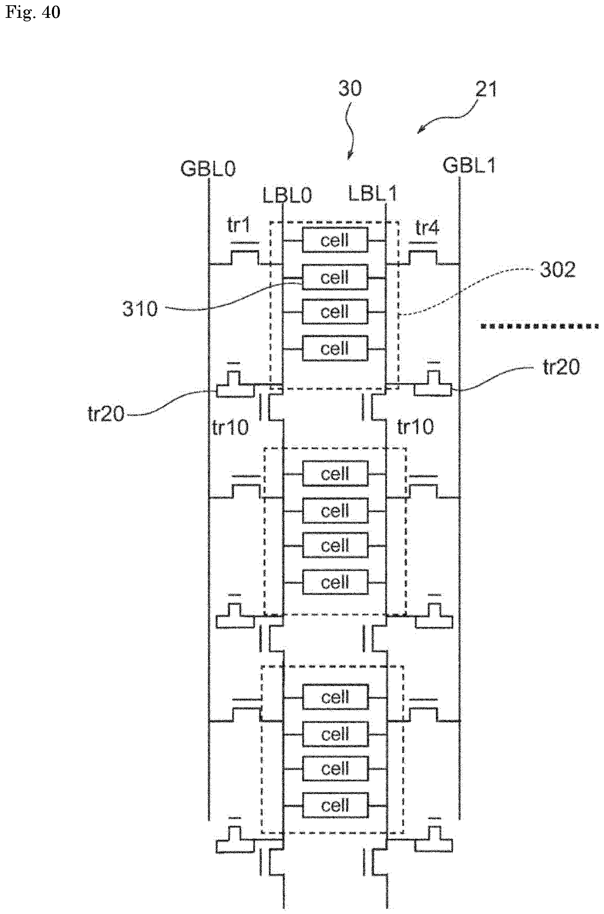

   Fig. 40 is a diagram showing an example of the configuration of a memory array unit according to a fifth embodiment.
[Fig. 41]

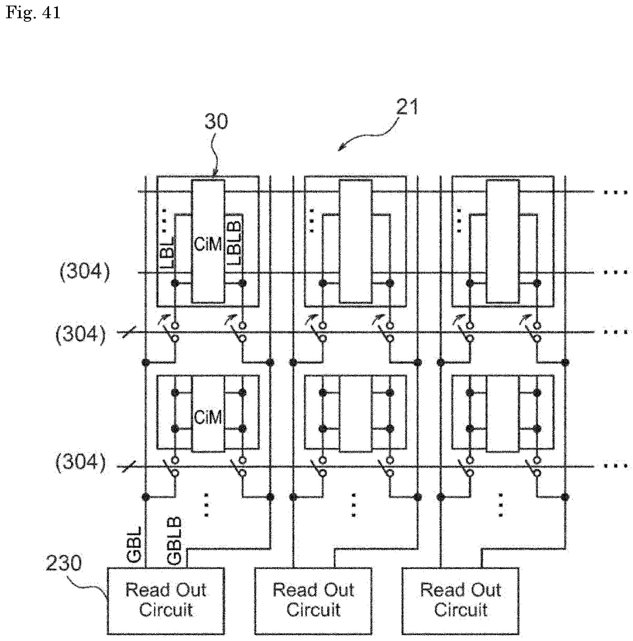

   Fig. 41 is a diagram showing an example of the configuration of a memory array unit according to a sixth embodiment.
[Fig. 42]

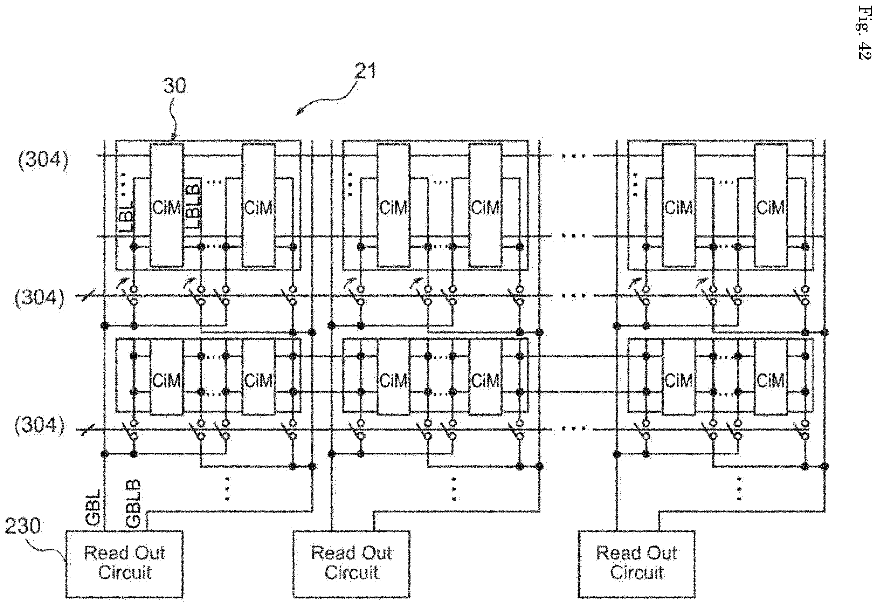

   Fig. 42 is a diagram showing an example of the configuration of memory array units grouped also in the row direction.
[Fig. 43]

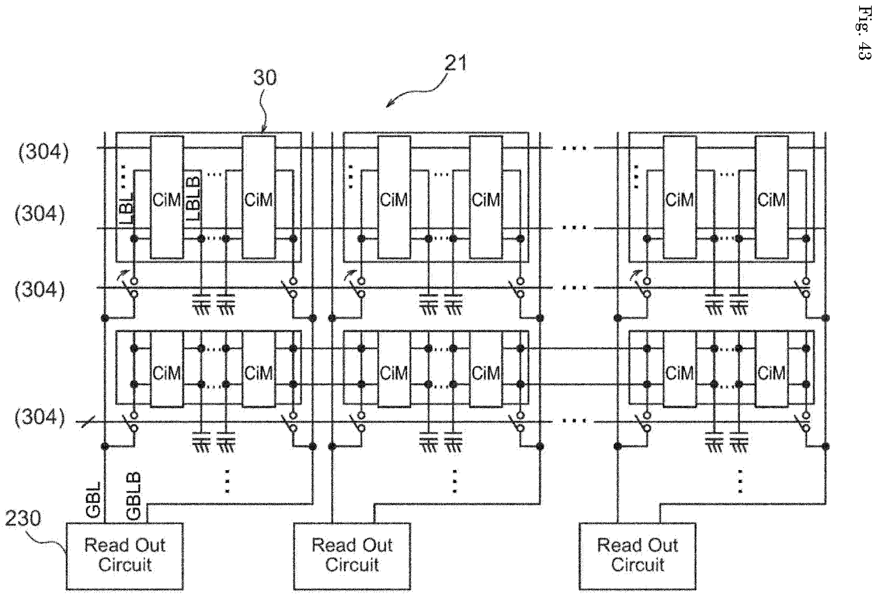

   Fig. 43 is a diagram showing an example of a configuration in which only one end side can be connected to a global bit line.
[Fig. 44]

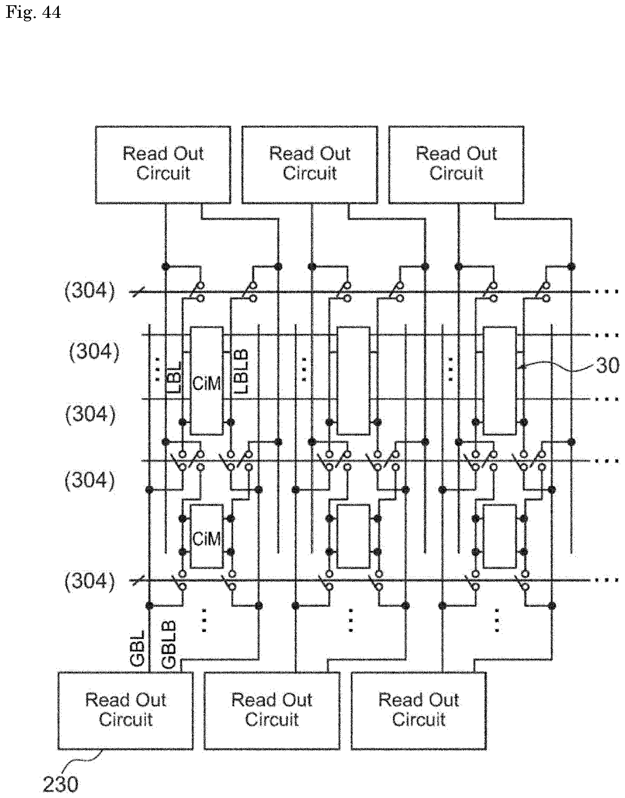

   Fig. 44 is a diagram showing an example of a configuration in which readout circuits are configured at both ends of a memory array unit.
[Fig. 45]

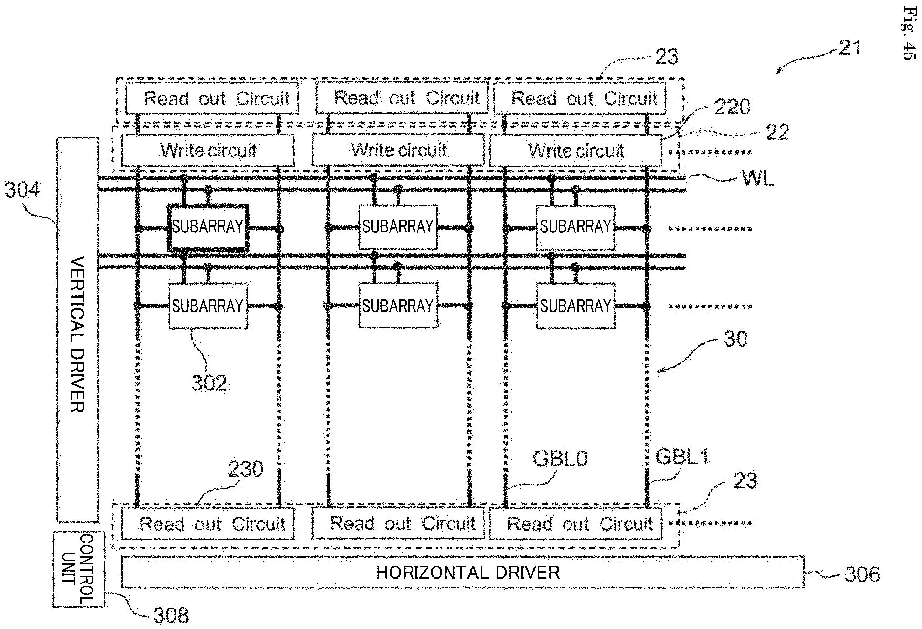

   Fig. 45 is a diagram showing an example of an arrangement together with a vertical driver, a horizontal driver, and a control unit.

### [Description of Embodiments]

Hereinafter, embodiments of the arithmetic device, imaging device, and computing method will be described with reference to the drawings. The following mainly describes the main components of the arithmetic device, imaging device, and computing method, but the arithmetic device, imaging device, and computing method may have components and functions that are not shown or described. The following description does not exclude components or functions that are not illustrated or described.

### (First Embodiment)

Fig. 1 is a block diagram showing a configuration of an imaging device according to a first embodiment. The imaging device 1 shown in Fig. 1 includes a pixel array unit 11, a pixel control circuit 12, a pixel signal processing circuit 13, a horizontal drive circuit 14, a logic circuit 15, a memory array unit 21, a CIM input control circuit 22, a CIM readout circuit 23, a signal processing circuit 31, a memory 32, and an input/output unit 33. Note that the memory array unit 21, the CIM input control circuit 22, and the CIM readout circuit 23 according to this embodiment constitute an arithmetic device 100.

A plurality of pixels are arranged two-dimensionally in the pixel array unit 11. Each pixel generates a pixel signal S12 by photoelectrically converting incident light based on a plurality of types of pixel control signals S11 from the pixel control circuit 12. In addition, each pixel is configured to output the pixel signal S12 in one direction towards the pixel signal processing circuit 13.

The pixel control circuit 12 is configured, for example, by a shift register, and inputs the pixel control signal S11 to each pixel of the pixel array unit 11 via a pixel drive wiring (not shown in Fig. 1). By using this pixel control signal S11, the pixel control circuit 12 sequentially selects and scans each pixel of the pixel array unit 11, and outputs the pixel signal S12 of each pixel to the pixel signal processing circuit 13.

The pixel signal processing circuit 13 performs CDS (Correlated Double Sampling) processing to remove pixel-specific fixed pattern noise and AD (Analog to Digital) conversion processing on the pixel signal S12 read from the pixel array unit 11. The image signal S13 processed by the pixel signal processing circuit 13 is input to the CIM input control circuit 22. The horizontal drive circuit 14 is configured, for example, by a shift register and sequentially outputs horizontal scanning pulses to the pixel signal processing circuit 13. As a result, for example, the image signal S13 held in the pixel signal processing circuit 13 is sequentially output to the CIM readout circuit 23.

The logic circuit 15 receives a clock signal input from the outside and data instructing the operation mode and the like and controls the operation of the entire imaging device 1. For example, the logic circuit 15 generates a vertical synchronization signal, a horizontal synchronization signal, and the like based on the input clock signal, and supplies them to the pixel control circuit 12, the pixel signal processing circuit 13, the horizontal drive circuit 14, the CIM input control circuit 22, and the CIM readout circuit 23, and the like. The memory array unit 21 outputs a signal S15 indicating the result of a product-sum operation in an analog manner using a plurality of memory cells in one direction toward the CIM readout circuit 23.

The CIM input control circuit 22 is configured, for example, by a shift register, and inputs a memory cell control signal S14 associated with the image signal S13 to each memory cell of the memory array unit 21 via a memory cell drive wiring (not shown in Fig. 1). That is, the CIM input control circuit 22 selects and scans each memory cell of the memory array unit 21 sequentially or collectively according to this memory cell control signal S14, and stores data related to the pixel signal S12 of each pixel in each memory cell of the memory array unit 21.

The CIM readout circuit 23 performs AD conversion processing and the like on the signal S15 read from the memory array unit 21. The signal S16 processed by the CIM readout circuit 23 is input to the signal processing circuit 31. The signal S16 may be intermediate data at an intermediate stage of image recognition. The signal processing circuit 31 performs conversion processing using an activation function, pooling processing, and the like on the signal S16 input from the CIM readout circuit 23, and outputs the processing result to the input/output unit 33. Note that some of these processes may be performed in the memory array unit 21 or in the CIM readout circuit 23. In addition, when signal processing is performed a plurality of times, the CIM readout circuit 23 may perform several signal processes, and then the signal processing circuit 31 may perform the remaining signal processes. In this way, by sharing the signal processing between the CIM readout circuit 23 and the signal processing circuit 31, it is possible to avoid concentration of the processing load. Furthermore, the signal processing circuit 31 can store parameters and the like input from an external image processing device via the input/output unit 33 in the memory 32, and can appropriately select and execute signal processing based on instructions from the external image processing device. The memory 32 stores data of parameters and the like required for signal processing performed by the signal processing circuit 31. The memory 32 may also have a frame memory for storing image signals in processing such as demosaic processing.

The input/output unit 33 outputs signals sequentially input from the signal processing circuit 31 to an external image processing device, such as a downstream ISP (Image Signal Processor). The input/output unit 33 also supplies signals and parameters input from an external image processing device to the signal processing circuit 31 and the logic circuit 15. The input/output unit 33 also writes data values indicating the learning results provided from the outside into the memory cells of the memory array unit 21, and can also update the learning results through the input/output unit 33 by reflecting the results calculated by the signal processing circuit 31.

Fig. 2 is a block diagram showing an example of the configuration of the memory array unit 21. As shown in Fig. 2, the memory array unit 21 has a plurality of subarray units 30, a vertical driver 304, a horizontal driver 306, and a control unit 308. The memory array unit 21 is also configured, for example, by semiconductor elements.

The memory array unit 21 includes a subarray unit 30 in which a plurality of subarrays 302 are connected in a column, and the plurality of subarray units 30 are arranged in a column. The plurality of memory array units 21 may also be arranged in a matrix. The memory array units 21 arranged in a matrix may be called a tile structure.

In addition, at least one memory cell is arranged in the subarray 302. In the subarray according to this embodiment, for example, a plurality of memory cells 310 (see Fig. 3) are arranged in a column. As a result, the memory array unit 21 has the memory cells 310 (see Fig. 3) arranged two-dimensionally.

The CIM input control circuit 22 has a plurality of write circuits 220. In addition, the CIM readout circuit 23 has a plurality of readout circuits 230.

The vertical driver 304 can control the switching elements in the subarray unit 30 via the word lines WL, which are horizontal signal lines, according to the control of the control unit 308. As a result, the vertical driver 304 can select the memory cells in the subarray unit 30 in units of horizontal rows.

The horizontal driver 306 can control the plurality of write circuits 220 and the plurality of readout circuits 230 for each column under the control of the control unit 308. For example, the write circuit 220 can control the potential of the global bit lines GBL0 and GBL1 between a predetermined high potential and a predetermined low potential. The readout circuit 230 can perform analog-to-digital conversion of the potential read from the global bit lines GBL0 and GBL1. The control unit 308 includes a CPU, for example, and controls the entire arithmetic device 100 (see Fig. 1).

Fig. 3 is a block diagram showing an example of the configuration of a subarray 302 connected between the local bit lines LBL0 and LBL1. The subarray 302 has a plurality of memory cells 310. In this embodiment, for the sake of simplicity, the number of subarrays 302 and the number of memory cells 310 will be described as several, but the present invention is not limited to this.

The memory cell 310 is a memory cell in which data (signal value) can be written and read. The memory cell 310 is, for example, an SARM. The ends of the memory cell 310 are connected between the local bit lines LBL0 and LBL1 via, for example, a switching element.

This allows data to be written and read for each memory cell 310. The memory cell 310 is also configured to be able to apply a potential corresponding to the stored data to the local bit lines LBL0 and LBL1.

The local bit lines LBL0 and LBL1 of each subarray 302 are formed with parasitic capacitances ca to cd. The global bit lines GBL0 and GBL1 are also formed with a parasitic capacitance call. These parasitic capacitances are, for example, configured with a metal wiring within a semiconductor element. This allows the capacitance ratio of the parasitic capacitances ca to cd and call for each subarray unit 30 constituting the memory array unit 21 to be constant. The local bit lines LBL0 and LBL1 of each subarray 302 are connected to the global bit lines GBL0 and GBL1 via transistors tr1 and tr4.

In this embodiment, in the case of CIM (computing in memory) driving, for example, data read from the global bit line GBL0 is added, and data read from the global bit line GBL1 is subtracted. Note that data read from the global bit line GBL0 may be subtracted, and data read from the global bit line GBL1 may be added.

### (Product-sum Operation of CIM)

In the case of CIM driving, for example, the memory cells 310 of each subarray 302 are electrically connected to the global bit lines GBL0 and GBL1 in sequence. Fig. 3 shows an example in which the second memory cell 310 is read. Here, an example will be described in which the global bit lines GBL0 and GBL1 and the local bit lines LBL0 and LBL1 are set to a ground potential as a precharge before the product-sum operation.

The stored data (signal value) of the second memory cell 310 in each subarray 302 is (0,1), (0,1), (1,0), and (0,1), respectively. For example, 0 in (0,1) corresponds to the ground potential, and 1 corresponds to the VDD potential. Note that, as a precharge before the product-sum operation, the global bit lines GBL0 and GBL1 and the local bit lines LBL0 and LBL1 may be set to a predetermined potential to read the charge. In this case, the drop in potential from a predetermined potential corresponds to the data of the memory cell 310.

As shown in Fig. 3, when the second memory cell 310 is read, the parasitic capacitance ca of the local bit line LBL0 stores a charge k1×Qa proportional to ca×0, the parasitic capacitance cb stores a charge k1×Qb proportional to cb×0, the parasitic capacitance cc stores a charge k1×Qc proportional to cc×1, and the parasitic capacitance cd stores a charge k1×Qd proportional to cd×0.

When the transistor tr1 of each subarray 302 is turned on, the parasitic capacitances ca to cd are connected in parallel, and the charge capacitance Qall1 is Qall1=k1(Qa+Qb+Qc+Qd). At this time, the parasitic capacitance call is connected in series with the parallel-connected parasitic capacitances ca to cd, so its charge capacitance Qall2 is Qall2=Qall1×(ca+cb+cct+cd)/call=k1×(ca×0+cb×0+cc×1+cd×0)/call. In the readout circuit 230, a potential proportional to Qall2 is converted into a digital value D.

Similarly, the parasitic capacitance ca of the local bit line LBL1 stores a charge k1×Qax proportional to ca×1, the parasitic capacitance cb stores a charge k1×Qbx proportional to cb×1, the parasitic capacitance cc stores a charge k1×Qcx proportional to cc×0, and the parasitic capacitance cd stores a charge k1×Qdx proportional to cd×1.

Next, when the transistor tr4 of each subarray 302 is turned on, the raw capacitances ca to cd are connected in parallel, and the charge capacitance Qallx1 is Qallx1 = k1×(Qax+Qbx+Qcx+Qdx). At this time, call is connected in series with the parallel-connected ca to cd, so the charge capacitance Qallx2 = Qallx1×(ca+cb+cc+cd)/cal = k1×(ca×1+cb×1+cc×0+cd×1)/call. The readout circuit 230 converts the potential proportional to Qallx2 into a digital value Dx.

Then, the readout circuit 230 subtracts the digital value Dx from the digital value D. This results in D-Dx=k1×(ca×0+cb×0+cc×1+cd×0)/call-k1×(ca×1+cb×1+cc×0+cd×1)/call=k1×(ca×(-1)+cb×(-1)+cc×(+1)+cd×(-1)). In this case, if k1×ca/call is coefficient a, k1×cb/call is coefficient b, k1×cb/call is coefficient c, and k1×cd/call is coefficient b, then this is equivalent to the operation a×(-1)+b×(-1)+c×(+1)+d×(-1). In this way, in the memory array unit 21 according to this embodiment, the charges are stored in the parasitic capacitances ca to cd at a potential corresponding to the data, a digital value proportional to the stored charges is generated, and a product-sum operation can be performed.

Fig. 4 is a diagram showing an example of an equivalent circuit of Fig. 3. The memory cell 310 is configured as a static random access memory (SRAM). Fig. 5 is a diagram showing an example in which the memory cell 310 is configured as a six-transistor SRAM. As shown in Figs. 4 and 5, the word lines WL from the vertical driver 304 (see Fig. 2) are connected to the gates of the transistors tr1 to tr4. As shown in Figs. 4 and 5, when setting (0,1) in the memory cell 310, the transistors tr1 to tr4 are turned on, and the write circuit 220 (see Fig. 2) puts the global bit line GBL0 to ground (GND) potential and the global bit line GBL1 to a VDD potential. Note that the transistors tr1 and tr2 in this embodiment correspond to the first switching element, the transistors tr3 and tr4 in this embodiment correspond to the second switching element, the global bit lines GBL0 and GBL1 correspond to the first signal line, and the local bit lines LBL0 and LBL1 correspond to the second signal line.

On the other hand, when setting (1,0) in the memory cell 310, the transistors tr1 to tr4 are turned on, and the write circuit 220 (see Fig. 2) puts the global bit line GBL0 to a VDD potential and the global bit line GBL1 to a ground potential. Although the memory cell 310 according to this embodiment is configured as a complementary output SRAM, the present invention is not limited to this. For example, if a potential corresponding to the data stored in the memory cell 310 can be applied to the parasitic capacitances ca to cd, a product-sum operation corresponding to the data stored in the memory cell 310 is possible. The first read signal line may be configured as one line instead of two lines.

Fig. 6 is a block diagram showing an example of the configuration of the readout circuit 230. In the readout circuit 230, an ADC 221 and a latch circuit 224 are arranged for each of the global bit lines GBL0 and GBL1.

The ADC 221 converts an analog output signal Aout from a corresponding column into a digital signal Dout. This AD conversion is also called "reading" of an analog signal. This ADC 221 is, for example, a single-slope ADC, and includes a comparator 222 and a counter 223.

The comparator 222 compares the reference signal RMP from the DAC (not shown) with the output signal Aout. The comparator 222 supplies the comparison result CMP to the counter 223. The counter 223 counts the count value until the comparison result CMP is inverted. The counter 223 outputs a digital signal Dout indicating the count value to the latch circuit 224. The counter 223 can also perform either up-counting or down-counting, and can switch from one of up-counting or down-counting to the other under the control of the timing control circuit 212.

The latch circuit 224 on the global bit line GBL0 side holds the digital signal D, and the latch circuit 224 on the global bit line GBL1 side holds the digital signal Dx. These latch circuits 224 output signals under the control of the control circuit 308 (see Fig. 2). The differential circuit 226 calculates the difference between the digital signals Dx and D, and outputs the result to the signal processing circuit 31 (see Fig. 1).

Note that in this embodiment, the ADC 221 is arranged for each of the global bit lines GBL0 and GBL1, but the present invention is not limited to this. For example, a system in which one ADC 221 corresponds to all columns may be adopted. In addition, the ADC 221 may be, for example, a single-slope ADC, a SAR ADC (Successive Approximation Register Analog to Digital Converter), a delta sigma ADC, a pipeline ADC, a double integral-type ADC, or a flash ADC. In addition, an AutoZero based on a reset signal may be performed, and CDS may be performed. When there is one VSL, a one-input ADC is preferable. On the other hand, when two lines are used to express positive and negative, two one-input ADCs may be prepared and the difference of the ADC results may be taken in the digital domain, or a two-input ADC may be used to ADC the difference. For example, in the case of a two-input ADC, an SAR-ADC may be used. In addition, in the case of a two-input ADC, an operation such as ReLU may be performed. This ReLU is a function that outputs zero when a negative signal is obtained when a positive and negative signal are added. Note that if it is clear that the output will become negative during the ADC operation, the ADC operation may be stopped midway to confirm the zero output.

### (Read Driving)

The first read driving according to this embodiment has, for example, three read modes. Mode 1 is a mode in which a product-sum operation is performed each time the memory cells 310 of each row of each subarray 302 are read. Mode 2 is a mode in which a product-sum operation is performed after all the memory cells 310 of each row of each subarray 302 are read. Mode 3 is a mode in which a product-sum operation is performed each time the memory cells 310 in each row of each subarray 302 are read a plurality of times. Here, an example is described in which each read is started after writing to the memory cells 310 has been completed. Note that although the operation on the local bit line LBL1 side is described, the operation on the local bit line LBL0 side is similar.

Precharging according to this embodiment means, for example, setting the global bit line GBL1 and the local bit line LBL1 to a predetermined potential before reading data to the parasitic capacitances ca to cd and the parasitic capacitance call.

Here, an example of read driving in Mode 1 will be described with reference to Figs. 7 to 9. Fig. 7 is a diagram showing an example of a pulse signal supplied from the vertical driver 304 to the word line WL of each memory cell 310. The horizontal axis represents time. Signals a to d show pulse signals applied to the gates of transistors tr3 and tr4 (see Figs. 4 and 5). a to d correspond to the order from the top of each subarray 302 in Fig. 3 (opposite the readout circuit 230).

When a high-level signal is applied to the transistors tr3 and tr4, the transistors tr3 and tr4 are turned on. For example, signal a shows the top subarray 302 in Fig. 3. Global-on (GBLON) indicates the turn-on state of transistors tr1 and tr2 (see Figs. 4 and 5).

Fig. 8 is a diagram schematically showing the potential fluctuation of the local bit line LBL0 when the driving shown in Fig. 7 is performed. The horizontal axis represents time and corresponds to Fig. 7. The vertical axis represents potential. The potential fluctuation corresponds to the potential corresponding to the data of the memory cell 310. In this description, the precharge is set to a predetermined potential, so the potential corresponding to the data is shown as a drop in potential. On the other hand, the potential corresponding to the signal value 0 has no potential fluctuation. When the precharge is set to ground, the line of the reference potential corresponds to the ground potential, and the absolute value of the potential fluctuation is proportional to the amount of stored charge.

Fig. 9 is a diagram showing the potential fluctuation of the global line GBL1 when the driving shown in Fig. 7 is performed in Mode 1. The horizontal axis represents time and corresponds to Fig. 7. The vertical axis corresponds to the potential Vswing of the global line GBL1.

As shown in Figs. 7 to 9, the vertical driver 304 turns the transistors tr3 and tr4 in the first row of each subarray 302 on or off at time t1 after the precharge of the local bit line LBL1 is completed, depending on the stored data. For example, if the data is 1, the transistors are turned on, and if the data is 0, the transistors are turned off.

As a result, the charges corresponding to the signal value of the memory cell 310 in the first row of each subarray 302 are stored in the parasitic capacitances ca to cd. For example, if the stored data is 1, the potential of VDD is applied to the local bit line LBL1. Next, the transistors tr1 and tr2 (see Figs. 4 and 5) of each subarray 302 are turned on, and the data in the first row of each subarray 302 is capacitively divided into the parasitic capacitance call at the timing of global-on. As described above, the processing on the global bit line GLBO side is also performed in the same manner. Then, the signal corresponding to the potential of the global bit line GLBO and the signal corresponding to the potential of the global bit line GLB1 are subjected to a product-sum operation in the readout circuit 230.

Next, the vertical driver 304 turns the transistors tr3 and tr4 in the second row of each subarray 302 on or off according to the stored data at time t2 after the precharge of the local bit line LBL1 is completed. As a result, the charges corresponding to the signal value of the memory cell 310 in the second row of each subarray 302 are stored in the parasitic capacitances ca to cd. Next, the transistors tr1 and tr2 (see Figs. 4 and 5) of each sub array 302 are turned on, and the data in the second row of each subarray 302 is capacitively divided into the parasitic capacitance call at the timing of global-on. Then, the signal corresponding to the potential of the global bit line GLBO and the signal corresponding to the potential of the global bit line GLB1 are subjected to a product-sum operation in the readout circuit 230.

Next, at time t3 after the precharge of the local bit line LBL1 is completed, the vertical driver 304 turns the transistors tr3 and tr4 in the second row of each subarray 302 on or off according to the stored data. As a result, the charges corresponding to the signal value of the memory cell 310 in the third row of each subarray 302 are stored in the parasitic capacitances ca to cd. Next, the transistors tr1 and tr2 (see Figs. 4 and 5) of each sub array 302 are turned on, and the data in the third row of each subarray 302 is capacitively divided into the parasitic capacitance call at the timing of global-on. Then, the signal according to the potential of the global bit line GLBO and the signal according to the potential of the global bit line GLB1 are subjected to a product-sum operation in the readout circuit 230.

Next, at time t4 after the precharge of the local bit line LBL0 is completed, the vertical driver 304 turns the transistors tr3 and tr4 in the fourth row of each subarray 302 on or off according to the stored data. As a result, the charges corresponding to the signal value of the memory cell 310 in the fourth row of each subarray 302 are stored in the parasitic capacitances ca to cd. Next, the transistors tr1 and tr2 (see Figs. 4 and 5) of each sub array 302 are turned on, and the data in the third row of each subarray 302 is capacitively divided into the parasitic capacitance call at the timing of global-on. Then, the signal according to the potential of the global bit line GLBO and the signal according to the potential of the global bit line GLB1 are subjected to a product-sum operation in the readout circuit 230.

In Modes 2 and 3, the global bit line GBL1 is precharged only once before reading. On the other hand, the local bit line LBL1 is precharged every time data is read. Therefore, in Modes 2 and 3, since the global bit line GBL1 is not precharged again, precharging is performed, for example, using a dedicated line (not shown) for precharging the local bit line LBL1.

Fig. 10 is a diagram showing the potential fluctuation of the global line GBL1 when the driving shown in Fig. 7 is performed in Mode 2. The horizontal axis represents time and corresponds to Fig. 7. The vertical axis corresponds to the potential Vswing of the global line GBL. As shown in Fig. 10, in Mode 2, charge sharing is performed on the global bit line GBL1 a plurality of times before the product-sum operation is performed in the readout circuit 230. As described above, the processing on the global bit line GLBO side is performed in the same manner. Then, the signal corresponding to the potential of the global bit line GLBO and the signal corresponding to the potential of the global bit line GLB1 are subjected to a product-sum operation in the readout circuit 230.

In this way, in Mode 1, a product-sum operation is performed each time the memory cell 310 of each row of each subarray 302 is read, so that it is possible to obtain the result of the product-sum operation of the memory cell 310 of each row of each subarray 302. On the other hand, in Mode 2, a product-sum operation is performed after all the memory cells 310 of each row of each subarray 302 are read, so that it is possible to perform the product-sum operation of all the memory cells 310 simultaneously, and the number of computation processes can be reduced.

Here, an example of control of repeated reading in Mode 3 will be described with reference to Figs. 11 to 13. Mode 3 differs from Mode 1 in that the memory cell 310 of each row of each subarray 302 is repeatedly read. Here, an example of repeatedly reading the memory cell 310 in the first row of each subarray 302 four times will be described.

Fig. 11 is a diagram showing an example of a pulse signal supplied from the vertical driver 304 to the word line WL of each memory cell 310. The horizontal axis represents time. Signals a to d indicate pulse signals applied to the gates of transistors tr3 and tr4 (see Figs. 4 and 5). When a high-level signal is applied to transistors tr3 and tr4, the transistors tr3 and tr4 are turned on. Signals a to d correspond to the subarrays 302 in Fig. 3. For example, signal a indicates the top subarray 302 in Fig. 3. Global-on (GBLON) indicates the turn-on state of transistors tr1 and tr2 (see Figs. 4 and 5). That is, this shows an example in which the memory cells 310 in the first row of each subarray 302 are repeatedly read at times t1 to t4.

Fig. 12 is a diagram schematically showing the potential fluctuation of the local bit line LBL1 when the driving shown in Fig. 11 is performed. The horizontal axis represents time and corresponds to Fig. 11. The vertical axis represents potential.

Fig. 13 is a diagram showing the potential fluctuation of the global bit line GBL1 when the driving shown in Fig. 7 is performed in Mode 3. The horizontal axis represents time and corresponds to Fig. 11. The vertical axis corresponds to the potential Vswing of the global bit line GBL1.

As shown in Figs. 11 to 13, the vertical driver 304 turns the transistors tr3 and tr4 in the first row of each subarray 302 on or off at time t1 after the precharge of the global bit line GBL01 and the local bit line LBL1 is completed. As a result, the charges corresponding to the signal value of the memory cell 310 in the first row of each subarray 302 are stored in the parasitic capacitances ca to cd. Next, the transistors tr1 and tr2 (see Figs. 4 and 5) of each subarray 302 are turned on, and the data in the first row of each subarray 302 is capacitively divided into the parasitic capacitance call at the timing of global-on.

Next, the vertical driver 304 turns the transistors tr3 and tr4 in the first row of each subarray 302 on or off at time t2 after the precharge of the local bit line LBL0 is completed. As a result, the charges corresponding to the signal values of the memory cells 310 in the first row of each subarray 302 are stored again in the parasitic capacitances ca to cd. Next, the transistors tr1 and tr2 (see Figs. 4 and 5) of each subarray 302 are turned on, and the data in the second row of each subarray 302 is capacitively divided into the parasitic capacitance call at the timing of global-on.

Next, the vertical driver 304 turns the transistors tr3 and tr4 in the first row of each subarray 302 on or off at time t3 after the precharge of the local bit line LBL0 is completed. As a result, the charges corresponding to the signal value of the memory cell 310 in the first row of each subarray 302 are stored again in the parasitic capacitance ca to cd. Next, the transistors tr1 and tr2 (see Figs. 4 and 5) in each subarray 302 are turned on, and the data in the second row of each subarray 302 is capacitively divided into the parasitic capacitance call at the timing of global-on.

Next, the vertical driver 304 turns the transistors tr3 and tr4 in the fourth row of each subarray 302 on or off at time t4 after the precharge of the local bit line LBL0 is completed. As a result, the charges corresponding to the signal value of the memory cell 310 in the fourth row of each subarray 302 are stored again in the parasitic capacitances ca to cd. Next, the transistors tr1 and tr2 (see Figs. 4 and 5) of each subarray 302 are turned on, and the data in the third row of each subarray 302 is divided by the parasitic capacitance call at the timing of global-on. As described above, the processing on the global bit line GLBO side is performed in the same manner. Then, the signal corresponding to the potential of the global bit line GLBO and the signal corresponding to the potential of the global bit line GLB1 are subjected to a product-sum operation in the readout circuit 230. By performing such processing, it is possible to perform computation processing in which the coefficient is an integer multiple, for example, 4 times, corresponding to repeated reading, such as 4{a×(-1)+b×(-1)+c×(+1)+d×(-1)}.

Note that in this embodiment, the precharge is described as being set to a predetermined high potential, but the present invention is not limited to this. For example, as described above, the global bit line GBL0 and the local bit line LBL0 may be precharged to the ground potential. In this case, the precharge is shown as setting the global bit line GBL0 and the local bit line LBL0 to the ground level, and the potential fluctuation appearing as rising in a direction from the ground level (see Figs. 8, 9, 10, 12, and 13). In this way, the precharge may be set to the ground potential.

As described above, according to this embodiment, the local bit lines LBL0 and LBL1 for each subarray 302 are formed with parasitic capacitances ca to cd that are in a predetermined ratio to the parasitic capacitance call of the global bit lines GLBO and GBL1, and a potential corresponding to the signal value of the memory cell 310 for each subarray 302 is applied to the global bit lines GLBO and 1 for each subarray 302. As a result, the charges corresponding to the signal value of the memory cell 310 can be stored and added in the parasitic capacitances ca to cd, and then, the charges can be read by the global bit lines GLBO and 1. A product-sum operation (for example, a×(+1)+b×(+1)+c×(-1)) in which the signal value of the memory cell 310 is multiplied by coefficients a to d proportional to the parasitic capacitances ca to cd can be performed on the memory array.

### (Modification 1 of First Embodiment)

Fig. 14 is a block diagram showing an imaging device 1 according to Modification 1 of the first embodiment. This configuration example differs from the configuration example of the subarrays 302 shown in Fig. 3 in that the parasitic capacitance ca of the first subarray 302 and the parasitic capacitance ca of the second subarray 302 have the same value. This allows for computation processing with a coefficient doubled, such as 2a×(+1)+b×(+1)+c×(-1).

### (Modification 2 of First Embodiment)

Fig. 15 is a block diagram showing an imaging device 1 according to Modification 2 of the first embodiment. This configuration example differs from the configuration example of the subarray 302 shown in Fig. 14 in that the first subarray 302 and the second subarray 302 are integrated. This allows, for example, 2a×(+1) computation processing to be performed in one read.

### (Modification 3 of First Embodiment)

Fig. 16 is a block diagram showing an imaging device 1 according to Modification 3 of the first embodiment. This configuration example differs from the configuration example of the subarray 302 shown in Fig. 3 in that each of the global bit lines GBL0 and GBL1 of each column can be divided by a plurality of capacitances c10 and c20.

Dividing the voltage by a plurality of capacitances c10 and c20 is equivalent to multiplying the left global bit lines GBL0 and GBL1 by coefficients Xa, Xb, Xc, and Xd and adding them to the right global bit lines GBL0 and GBL1. For example, when the same data is stored in the subarrays 302 of the first and second columns, it is equivalent to multiplying and adding the coefficients Xa, Xb, Xc, and Xd, as in Xa×a×(+1)+Xb×b×(+1)+Xc×c×(-1)+Xd×c×(+1). Note that although the capacitors c10 and c20 are shown in Fig. 16, the present invention is not limited to this. For example, a configuration may be adopted in which more capacitors are connected in parallel. Furthermore, a configuration may be adopted in which a plurality of capacitors are connected in series to each of the global bit lines GBL0 and GBL1 of each column.

### (Modification 4 of First Embodiment)

Fig. 17 is a block diagram showing an imaging device 1 according to Modification 4 of the first embodiment. This configuration example differs from the configuration example of the subarray 302 shown in Fig. 17 in that the parasitic capacitances of the local bit lines LBL0 and LBL1 are configured with variable capacitances vca to vcd. As a result, for example, by setting vca to vcd to the same value, the arithmetic device 100 can be used as a normal memory. The variable capacitance can be configured using elements such as MΩ resistors (MOR) (see JP 2020-113809A), FTJs (Ferroelectric Tunneling Junctions), and MTJs (Magnetic Tunnel Junctions).

On the other hand, in the case of a CIM (Computing in memory) mode in which computations are performed on a memory array, for example, by setting vca to vcd to capacitances corresponding to coefficients a to d of a×(+1)+b×(+1)+c×(-1), it becomes possible to perform a product-sum operation on a target memory array.

### (Modification 5 of First Embodiment)

Fig. 18A is a block diagram showing an imaging device 1 according to Modification 5 of the first embodiment. The configuration example of the subarray 302 shown in Fig. 18A differs from Modification 4 of the imaging device 1 according to the first embodiment in that the parasitic capacitance of the local bit lines LBL0 and LBL1 is configured by a variable capacitance unit (RMX) 400.

As shown in Fig. 18A, the variable capacitance unit 400 has a plurality of transistors tr5 and tr6 and a plurality of capacitances c30 and c40. One set of ends of the plurality of transistors tr5 and tr6 is connected to the local bit line LBLO, and a plurality of capacitances c30 and c40 are connected to the other set of ends of each transistor. The local bit line LBL1 side has the same configuration. The vertical driver 304 has a plurality of flip-flops 320 that control the variable capacitance unit 400 for each subarray 302. The output signal of the flip-flop 320 is input to the gates, which are the control electrodes of the plurality of transistors tr5 and tr6.

The flip-flop 320 outputs a signal to turn on one of a plurality of transistors tr5 and tr6 and turns off the remaining transistors under the control of control unit 308 (see Fig. 2). This makes it possible to change the parasitic capacitance of the local bit lines LBL0 and LBL1.

Fig. 18B is a diagram showing an example of the arrangement of subarrays 302 according to Modification 5 of the first embodiment. As shown in Fig. 18B, the write circuit 220 according to Modification 5 of the first embodiment (see Fig. 2) has a word line amplifier (WSA: Wr-amp) 220a and a word line amplifier control unit (WDV: Global Wt-Driver) 220b. The CIM readout circuit 23 has a global line amplifier (RSA: Global Rd-amp) 230a.

The word line amplifier 220a is disposed between a pair of subarrays 302. A variable capacitance unit 400 is formed at the end of the pair of subarrays 302. That is, the word line amplifier 220a and the variable capacitance unit 400 are alternately disposed between the subarrays 302. The word line amplifier control unit (WDV: Global Wt-Driver) 220b controls the word line amplifier 220a according to the control of the control unit 308 (see Fig. 2). The global line amplifier 230a amplifies the voltage of the global lines GBL0 and GBL1 and outputs it to the readout circuit 230. In this way, by forming the parasitic capacitance of the local bit lines LBL0 and LBL1 with the variable capacitance unit (RMX) 400, it becomes possible to use the arithmetic device 100 as a normal memory and to perform computations on the memory array.

### (Modification 6 of First Embodiment)

Fig. 19A is a diagram showing an example of the configuration of a memory cell 310 according to Modification 6 of the first embodiment. This configuration example differs from the configuration example of the memory cell 310 shown in Fig. 15 in that it has a resistor r3.

As shown in Fig. 19A, the transistors tr3 and tr4 are connected to the local bit lines LBL0 and LBL1 via the resistor r3. This allows the speed of supplying charge to the parasitic capacitance call to be delayed more than in the configuration example of the memory cell 310 shown in Fig. 15, and by disconnecting the transistors tr3 and tr4 before the charge is completely supplied, the amount of charge supplied from the memory cell 310 can be adjusted. In other words, by making the timing of disconnecting the transistors tr3 and tr4 different for each memory cell 310, it is possible to further adjust the value of the coefficient for each memory cell 310.

### (Modification 7 of First Embodiment)

Fig. 19B is a diagram showing an example of the configuration of a memory cell 310 according to Modification 7 of the first embodiment. This configuration example differs from the configuration example of the memory cell 310 shown in Fig. 19A in that the transistors tr3 and tr4 are NMOS transistors, while the transistors tr3b and tr4b are PMOS transistors. As a result, it is possible to achieve a function equivalent to that of the memory cell 310 according to Modification 6 of the first embodiment by inverting the high and low levels of the gate signal of the transistor tr3b.

### (Modification 8 of First Embodiment)

Fig. 19C is a diagram showing an example of the configuration of the memory cell 310 according to Modification 8 of the first embodiment. This configuration example differs from the configuration example of the memory cell 310 shown in Fig. 19A in that the transistor tr3 and the resistor r3 are configured with a transistor tr3c, and the transistor tr4 and the resistor r3 are configured with a transistor tr4c. The resistance of the transistor tr3c in the turn-on state is equivalent to the resistance of the resistor r3 connected in series with the resistance of the transistor tr3 in the turn-on state. The same is true for the transistor tr4c. As a result, the resistor r3 is not required.

### (Modification 9 of First Embodiment)

Fig. 19D is a diagram showing an example of the configuration of a memory cell 310 according to Modification 9 of the first embodiment. This configuration example differs from the configuration example of the memory cell 310 shown in Fig. 19B in that the transistor tr3b and the resistor r3 are configured with a transistor tr3d, and the transistor tr4b and the resistor r3 are configured with a transistor tr4d. The resistance of the transistor tr3d in the turn-on state is equivalent to the resistance of the resistor r3 connected in series with the resistance of the transistor tr3b in the turn-on state. The same is true for the transistor tr4d. As a result, the resistor r3 is not required.

### (Second Embodiment)

An imaging device 1 according to the second embodiment differs from the imaging device 1 according to the first embodiment in that the subarray unit 30 constituting the memory array unit 21 is configured for each of the global bit lines GBL0 and GBL1. The differences from the imaging device 1 according to the first embodiment will be described below.

Fig. 20 is a block diagram showing an example of the configuration of the memory array unit 21 according to the second embodiment. As shown in Fig. 20, in the memory array unit 21, a subarray unit 30 is configured for each of the global bit lines GBL0 and GBL1. This allows independent addition and subtraction operations to be performed for each of the global bit lines GBL0 and GBL1.

Fig. 21 is a block diagram showing a more detailed example of the configuration of the memory array unit 21 according to the second embodiment. As shown in Fig. 21, the memory array unit 21 has a plurality of subarrays 302 connected only to the global bit line GBL0 side, and a plurality of subarrays 302 connected only to the global bit line GBL1 side. As can be seen from this, it is possible to set the data stored in the plurality of subarrays 302 connected only to the global bit line GBL0 side and the data stored in the plurality of subarrays 302 connected only to the global bit line GBL1 side independently. This allows the addition process on the global bit line GBL0 side and the subtraction process on the global bit line GBL1 side to be performed independently.

As described above, according to this embodiment, the memory array unit 21 has the subarray unit 30 configured for each of the global bit lines GBL0 and GBL1. This allows independent addition and subtraction computations to be performed for each of the global bit lines GBL0 and GBL1.

### (Modification 1 of Second Embodiment)

Fig. 22 is a block diagram showing an imaging device 1 according to Modification 1 of the second embodiment. This configuration example differs from the configuration example of the subarray 302 shown in Fig. 21 in that the parasitic capacitances of the local bit lines LBL0 and LBL1 are configured with variable capacitances vca to vcd. This allows the arithmetic device 100 to be used as a normal memory by setting vca to vcd to the same value, for example. The variable capacitance can be configured using elements such as MΩ resistors (MOR) (see JP 2020-113809A), FTJs (Ferroelectric Tunneling Junctions), and MTJs (Magnetic Tunnel Junctions).

On the other hand, in the case of a CIM (Computing in memory) mode in which computations are performed on a memory array, it is possible to perform a product-sum operation on a target memory array by setting a capacitance according to coefficients a to d of, for example, a×(+1)+b×(+1)+c×(-1).

### (Third Embodiment)

An imaging device 1 according to the third embodiment differs from the imaging device 1 according to the first embodiment in that the memory cells 310 constituting the memory array unit 21 can change their coefficients depending on the potential and pulse width of a pulse signal. The differences from the imaging device 1 according to the first embodiment will be described below.

Fig. 23 is a block diagram showing an example of the configuration of the memory array unit 21 according to the third embodiment. As shown in Fig. 23, the memory array unit 21 has a plurality of subarrays 302 configured between global bit lines GBL0 and GBL1. The subarray 302 has a plurality of memory cells 310.

A parasitic capacitance c50 is configured in the local bit lines LBL0x and LBL1x of each subarray 302. In addition, a parasitic capacitance call is configured in the global bit lines GBL0 and GBL1. These parasitic capacitances are configured, for example, by a metal wiring.

As shown in Fig. 23, the memory cell 310 according to the third embodiment is composed of an SRAM, a plurality of transistors tr7 and tr8, and a plurality of resistors r. The SRAM has a structure equivalent to that shown in Fig. 5. Therefore, the memory cell 310 has local bit lines LBL0 and LBL1 (not shown) for setting data in the SRAM. As a result, data can be set in the same manner as in the SRAM according to the first embodiment.

The plurality of transistors tr7 and tr8 and the resistor r are connected in series. One end of the transistor tr7 is connected to the local bit line LBL0x, and one end of the resistor r is connected to the vertical driver 304 (see Fig. 2) via the word line act. The local bit line LBL1x side has the same structure. The gate of the transistor tr7 is connected to the vertical driver 304, and the gate of the transistor tr8 is connected to one end of the SRAM. Note that the plurality of transistors tr7 and tr8 according to this embodiment correspond to the second switching element. The number of switching elements does not have to be one, unlike this configuration.

### (Read Driving)

An example of read driving when performing a product-sum operation on the CIM of the memory array unit 21 according to the third embodiment will be described. Fig. 24 is a block diagram showing a word line with the same configuration as Fig. 23. WLa to WLp in Fig. 24 correspond to the word lines act connected to each memory cell 310. In addition, circles 1 to 4 indicate rows in the subarray 302.

Here, an example of read driving of the memory array unit 21 according to the third embodiment will be described using Fig. 25 to Fig. 27 while referring to Fig. 24. Fig. 25 is a diagram showing an example of pulse signals Pa to Po supplied from the vertical driver 304 to the word lines WLa to WLo of each memory cell 310. The horizontal axis represents time. The pulse signals Pa to Po indicate pulse signals applied to one end of the resistor r via the word lines WLa to WLo. In addition, circles 1 to 4 indicate rows in the subarray 302. The height of the pulse signals Pa to Po corresponds to the applied potential, and the pulse width corresponds to time.

Fig. 26 is a diagram showing the amount of potential fluctuation applied to the local bit line LBL0x of each subarray 302 when the pulse signals Pa to Po shown in Fig. 5 are applied. The horizontal axis represents time. The vertical axis represents the amount of potential fluctuation. The amounts of potential fluctuation LBL0xa to LBL0xo correspond to the amounts of potential fluctuation when the pulse signals Pa to Po are applied.

Fig. 27 is a diagram showing the potential fluctuation of the global line GBL0 when the driving shown in Fig. 26 is performed. The horizontal axis represents time and corresponds to Fig. 26. The vertical axis corresponds to the potential Vswing of the global line GBL0.

As shown in Figs. 25 to 27, after the precharge of the local bit line LBLx1 is completed, the vertical driver 304 applies a high-level signal to the gate of each transistor tr7, turning on each transistor tr7. In this case, the transistor tr8 is turned on when (1,0) is stored in the memory cell 310, and the transistor tr8 is turned off when (0,1) is stored in the memory cell 310.

Next, pulse signals Pa to Po are applied to one end of each resistor r via the word lines WLa to WLo. As a result, when (1,0) is stored in the memory cell 310, a current corresponding to the potential and pulse width of the pulse signals Pa to Po flows through the local bit line LBLx1. This current is stored in the parasitic capacitance c50 as a charge. The fluctuation in potential at this time depends on the potential of the pulse signals Pa to Po, as shown in Fig. 26, and the time of the fluctuation in potential depends on the pulse width. In this way, the charges corresponding to the potential and pulse width of the pulse signals Pa to Po are stored in the parasitic capacitance c50. As can be seen from these, the potential and pulse width of the pulse signals Pa to Po correspond to the coefficients of the product-sum operation. On the other hand, when (0,1) is stored in the memory cell 310, the transistor tr8 is in the turn-off state, so it does not contribute to the charge storage of the parasitic capacitance c50.

Next, as shown in Fig. 27, the transistors tr1 and tr2 (see Fig. 23) of each subarray 302 are turned on, and the charge of the parasitic capacitance c50 of each subarray 302 is capacitively divided into the parasitic capacitance call. The same processing is also performed on the global bit line GLB1 side. At this time, the potential and pulse width of the pulse signals Pa to Po on the global bit line GLB1 side can be made different from those on the global bit line GLBO side. Then, the signal corresponding to the potential of the global bit line GLBO and the signal corresponding to the potential of the global bit line GLB1 are subjected to a product-sum operation in the readout circuit 230. In this way, it is possible to perform a product-sum operation on the data of all the memory cells 310 of each subarray 302 according to the potential and pulse width of the pulse signals Pa to Po.

Fig. 28 is a diagram showing an example in which the pulse signals Pa to Po with different potentials and pulse widths are simultaneously applied to each subarray 302 for each column. In this case, it is possible to make the potentials and pulse widths of the pulse signals Pa to Po different for each subarray unit 30. This makes it possible to perform the operation shown in Fig. 29 and Fig. 30 described later at high speed.

Fig. 29 is a diagram showing the pixel values of the captured image and the calculation values of the convolution operation in a cube. There are C captured images having pixels of H vertically and W horizontally as input values (Input). The filter size for this convolution operation is R vertically and S horizontally. One calculation value of the output value (fmap) is the convolution operation in the range of R×S for C captured images. The coefficients of this convolution operation are the potential and pulse width of pulse signals Pa to Po. Each coefficient is sometimes referred to as a weighting coefficient. M corresponds to the number obtained by converting the coefficients in the range of R×S for C captured images, and H' vertically and W' horizontally correspond to the numbers calculated by moving the filter within H vertically and W horizontally, respectively.

Fig. 30 is a diagram showing an example of the configuration of the memory array unit 21 when the operation of Fig. 29 is performed. As shown in Fig. 30, by setting the number of memory cells in one column to R×S×C, it is possible to obtain one calculation value. As shown in Fig. 29, when M calculation values are obtained simultaneously, the number of columns can be M. The weighting coefficient at this time corresponds to the potential and pulse width of the pulse signals Pa to Po supplied to each column.

As described above, according to this embodiment, the transistor tr7 and the transistor tr8, one set of ends of which are connected to the local bit lines LBL0x and LBL1x, and the resistor r, the other end of which is connected to the word line WL, are connected in series, and the transistor tr8 is turned on according to the signal value stored in the memory cell 310, and the pulse signals Pa to Po are supplied to the word line WL. This allows the capacitance c50 to store the charges corresponding to the signal value of the memory cell and the potential and pulse width of the pulse signals Pa to Po, and allows the data of all memory cells 310 of the subarray 302 to be subjected to a product-sum operation according to the potential and pulse width of the pulse signals Pa to Po.

### (Modification 1 of Third Embodiment)

Fig. 31 is a block diagram showing a subarray 302 according to Modification 1 of the third embodiment. This configuration example differs from the configuration example of the subarray 302 shown in Fig. 24 in that the first subarray 302 and the second subarray 302 are integrated. This allows the number of transistors to be reduced.

### (Modification 2 of Third Embodiment)

Fig. 32 is a block diagram showing a subarray 302 according to Modification 2 of the third embodiment. Each of the global bit lines GBL0 and GBL1 of each column can be divided by a plurality of capacitances c10 and c20. Dividing the voltage by the plurality of capacitances c10 and c20 is equivalent to multiplying the left global bit lines GBL0 and GBL1 by coefficients Xa, Xb, Xc, and Xd and adding them to the right global bit lines GBL0 and GBL1.

### (Modification 3 of Third Embodiment)

Fig. 33 is a block diagram showing a subarray 302 according to Modification 3 of the third embodiment. In the subarray 302 according to Modification 3 of the third embodiment, the parasitic capacitance c50 can also be configured with a variable capacitance vc50. This makes it possible to further change the coefficients for each subarray 302 in an integrated manner.

### (Modification 4 of Third Embodiment)

Fig. 34 is a block diagram showing an example of the configuration of the memory array unit 21 according to Modification 4 of the third embodiment. This configuration example differs from the configuration example of the memory array unit 21 shown in Fig. 23 in that it has a resistor R.

As shown in Fig. 34, the transistors tr1 and tr2 are connected to the global bit lines GBL0 and GBL1 via a resistor R. This allows the speed of supplying charge to the parasitic capacitance call to be delayed more than in the configuration example of the memory array unit 21 shown in Fig. 33, and by disconnecting the transistors tr1 and tr2 before the charge is completely supplied, the amount of charge supplied from each subarray 302 can be adjusted. In other words, by making the timing of disconnecting the transistors tr1 and tr2 different for each subarray 302, it is possible to further adjust the coefficient value for each subarray 302.

### (Modification 5 of Third Embodiment)

Fig. 35 is a diagram showing a configuration example of a memory cell 310 according to Modification 5 of the third embodiment. The memory cell 310 shown in Fig. 35 has a transistor tr7a instead of the transistor tr7 and resistor r shown in Fig. 33. The resistance of the transistor tr7a in the turn-on state is equal to the resistance of the resistor r connected in series with the resistance of the transistor tr7 in the turn-on state. As a result, the resistor r is not required.

### (Fourth Embodiment)

An imaging device 1 according to the fourth embodiment differs from the imaging device 1 according to the third embodiment in that the subarray unit 30 constituting the memory array unit 21 is configured for each of the global bit lines GBL0 and GBL1. The differences from the imaging device 1 according to the third embodiment will be described below.

Fig. 36 is a block diagram showing an example of the configuration of the memory array unit 21 according to the fourth embodiment. As shown in Fig. 36, the memory array unit 21 has the subarray unit 30 configured for each of the global bit lines GBL0 and GBL1. This makes it possible to perform independent addition and subtraction operations for each of the global bit lines GBL0 and GBL1 in addition to the same effects as the imaging device 1 according to the third embodiment.

### (Modification 1 of Fourth Embodiment)

Fig. 37 is a block diagram showing an example of the configuration of the memory array unit 21 according to Modification 1 of the fourth embodiment. In the memory array unit 21 according to Modification 1 of the fourth embodiment, the parasitic capacitance c50 is configured with a variable capacitance vc50. This provides the same effect as the imaging device 1 according to the fourth embodiment, and further allows the coefficients of each subarray 302 to be changed in an integrated manner.

### (Modification 2 of Fourth Embodiment)

Fig. 38 is a block diagram showing an example of the configuration of the memory array unit 21 according to Modification 2 of the fourth embodiment. This configuration example differs from the configuration example of the memory array unit 21 shown in Fig. 37 in that it has a resistor R.

As shown in Fig. 38, the transistors tr1 and tr2 are connected to the global bit lines GBL0 and GBL1 via the resistor R. This allows the speed of charge supply to the parasitic capacitance call to be delayed more than in the configuration example of the memory array unit 21 shown in Fig. 37, and by disconnecting the transistors tr1 and tr2 before the charge is completely supplied, the amount of charge supplied from each subarray 302 can be adjusted. In other words, by making the timing of disconnecting the transistors tr1 and tr2 different for each subarray 302, it is possible to further adjust the coefficient value for each subarray 302.

### (Modification 3 of Fourth Embodiment)

Fig. 39 is a diagram showing a configuration example of a memory cell 310 according to Modification 3 of the fourth embodiment. The memory cell 310 shown in Fig. 39 has a transistor tr7a instead of the transistor tr7 and resistor r shown in Fig. 36. The resistance of the transistor tr7a in the turn-on state is equivalent to the resistance of the resistor r connected in series with the resistance of the transistor tr7 in the turn-off state. As a result, the resistor r is not required. It is also possible to make the potential supplied to the SRAM different for the word lines WBL and WBLB. This makes it possible to further adjust the values of the coefficients used in the product-sum operation.

### (Fifth Embodiment)

An imaging device 1 according to the fifth embodiment differs from the imaging devices 1 according to the first to fourth embodiments in that the imaging device 1 according to the fifth embodiment is configured so that the subarrays 302 can be connected to the local bit lines LBL0 and LBL1 via a connection transistor tr10. The differences from the imaging devices 1 according to the first to fourth embodiments will be described below.

Fig. 40 is a block diagram showing an example of the configuration of the memory array unit 21 according to the fifth embodiment. As shown in Fig. 40, the subarrays 302 are configured so that the local bit lines LBL0 and LBL1 can be connected to the transistor tr10. A second capacitance c60 (not shown) is connected to the local bit lines LBL0 and LBL1 for each subarray 302.

As a result, for example, when the transistor tr10 is connected to read the memory cell 310, the parasitic capacitance is twice the second capacitance c60. Moreover, the transistors tr10 and tr20 are transistors controlled to have opposite polarities, and the capacitance c20 of the transistor tr20 is configured to be half the capacitance c10 of the transistor tr10. As can be seen from this, for example, when the transistor tr10 is connected to read the memory cell 310, the transistors have a capacitance of 2×c60+c20, and it has a capacitance of c60+c20/2 when it is disconnected. In this way, it is possible to adjust the parasitic capacitance by taking into account the capacitance of the transistor tr10.

As described above, in the imaging device 1 according to this embodiment, the plurality of subarrays 302 are configured so that the local bit lines LBL0 and LBL1 can be connected by the transistor tr10. Therefore, when the memory cell 310 is read, the amount of stored charge can be changed by a multiple of 2 by turning the transistor tr10 on or off. As a result, the coefficient related to the memory cell 310 during the product-sum operation can be changed by a multiple of 2.

### (Sixth Embodiment)

An imaging device 1 according to the sixth embodiment differs from the imaging devices 1 according to the first to fifth embodiments in that a plurality of subarray units 30 are arranged two-dimensionally. The differences from the imaging devices 1 according to the first to fifth embodiments will be described below.

Fig. 41 is a block diagram showing an example of the configuration of a memory array unit 21 according to the sixth embodiment. As shown in Fig. 42, in the memory array unit 21 according to the sixth embodiment, a plurality of subarray units 30 are arranged two-dimensionally. Furthermore, the plurality of subarray units 30 in the same column are configured to be able to share a readout circuit 230 by switching a switching element. In addition, the subarray unit 30 used as an arithmetic unit and the subarray unit 30 used as a memory are configured to be able to be switched by switching the switching element. That is, in the memory array unit 21 according to the sixth embodiment, the subarray 302 used as an arithmetic unit (see Figs. 3 and 33, and the like) and the subarray 302 used as a memory are configured to be able to be switched by switching the switching element.

Fig. 42 is a block diagram showing an example of the configuration of the memory array units 21 grouped in the row direction as well. As shown in Fig. 42, a plurality of subarray units 30 are grouped in the row direction as well, and the plurality of subarray units 30 grouped in the row direction are also configured to be able to share the readout circuit 230 by switching the switching element.

Fig. 43 is a diagram showing an example in which only one end side of the subarray unit 30 is configured to be connectable to the global bit line GBL. As shown in Fig. 43, only the local bit line LBL on one end side of the subarray unit 30 is configured to be connectable to the global bit line GBL. Furthermore, a plurality of subarray units 30 are grouped in the row direction as well, and the plurality of subarray units 30 grouped in the row direction are also configured to be able to share the readout circuit 230 by switching the switching element.

Fig. 44 is a block diagram showing an example of the configuration in which the readout circuit 230 is configured at both ends of the memory array unit 21. Fig. 45 is a block diagram showing an example in which the configuration of Fig. 44 is arranged together with a vertical driver 304, a horizontal driver 306, and a control unit 308. As shown in Figs. 44 and 45, by enabling reading of the subarray unit 30 from two directions, it becomes possible to perform a product-sum operation at higher speeds.

The present technology can also employ the following configurations.

(1) An arithmetic device comprising:
   a first signal line;
   a first capacitance connected to the first signal line;
   at least one subarray connected to the first signal line; and
   a readout circuit that generates a digital signal according to a charge of the first signal line,
   wherein
   the subarray includes:
      a second signal line connected to the first signal line via a first switching element;
      a second capacitance connected to the second signal line; and
      at least one memory cell connected to the second signal line and capable of supplying a charge corresponding to a signal value to be stored to the second signal line.
(2) The arithmetic device according to (1), wherein
   the first capacitance and the second capacitance are parasitic capacitances formed in a metal layer of a semiconductor element.
(3) The arithmetic device according to (1), wherein
   a plurality of the subarrays are connected to the first signal line, and
   the second capacitance is different for each subarray.
(4) The arithmetic device according to (1), wherein
   a plurality of the subarrays are connected to the first signal line, and
   the second capacitance is a variable capacitance.
(5) The arithmetic device according to (4), wherein
   the memory cell is connected to the second signal line via a second switching element to supply the charge corresponding to the signal value to the second signal line.
(6) The arithmetic device according to (5), wherein
   the second switching element is configured by a single switching element or by connecting a plurality of switching elements in series,
   one end of the second switching element is connected to the second signal line,
   the second switching element is turned on or off depending on the stored data,
   a potential pulse signal is supplied from the other end of the second switching element, and a charge corresponding to a potential and a pulse width of the potential pulse signal is stored in the second capacitance.
(7) The arithmetic device according to (5), wherein
   the subarray has a plurality of the memory cells, and
   the memory cells are static random access memories (SRAMs) having the second switching elements.
(8) The arithmetic device according to (7), wherein
   the arithmetic device has:
   a mode in which the second signal line and the plurality of memory cells are sequentially turned on at different timings,
   a mode in which the second signal line and the plurality of memory cells are simultaneously turned on, and
   a mode in which the second signal line and the plurality of memory cells are repeatedly turned on at different timings.
(9) The arithmetic device according to (8), wherein
   when the plurality of subarrays are used as memories, the variable capacitances of each of the plurality of the subarrays have the same capacitance, and
   when the plurality of subarrays are used as arithmetic units, the variable capacitances of each of the plurality of the subarrays are changeable according to a rate of data addition.
(10) The arithmetic device according to (9), wherein
   among the plurality of subarrays, a subarray to be used as an arithmetic unit and a subarray to be used as a memory are configured to be able to be switched.
(11) The arithmetic device according to (9), further including:
   a first control unit that controls the first switching element and the second switching element; and
   a second control unit that controls a potential of the second signal line when data is written to the memory cell.
(12) The arithmetic device according to (5), wherein
   the subarray has a plurality of the memory cells, and
   the memory cell is composed of the second switching element and a flip-flop.
(13) The arithmetic device according to (1), wherein
   the second signal line is connected to the first signal line via the first switching element and a first resistor.
(14) The arithmetic device according to (5), wherein
   the memory cell is connected to the second signal line via the second switching element and a second resistor.
(15) The arithmetic device according to (5), wherein
   either the first switching element or the second switching element has a predetermined resistance value.
(16) The arithmetic device according to (5), further including:
   a first control unit that controls the first switching element and the second switching element; and
   a second control unit that controls a potential of the second signal line when data is written to the memory cell,
   a plurality of subarrays are connected in a column to the first signal line to form a subarray unit,
   a plurality of the subarray units are arranged in a column to form an array unit,
   the first control unit is arranged at both ends of one of the array units, and
   the second control unit is arranged at both ends of the other of the array units.
(17) The arithmetic device according to (16), wherein
   a plurality of the subarray units share the readout circuit.
(18) The arithmetic device according to (16), including:
   a plurality of the readout circuits, wherein
   at least one of the plurality of readout circuits is arranged at one end of the array unit, and
   at least one of the plurality of readout circuits is arranged at the other end of the array unit.
(19) An imaging device comprising:
   the arithmetic device according to (1); and
   a pixel array unit in which pixels that generate pixel signals obtained by photoelectrically converting incident light are arranged two-dimensionally, wherein
   image data obtained by converting the pixel signals into digital data is stored in the memory cells of the arithmetic device.
(20) A computing method for an arithmetic device, the arithmetic device including:
   a plurality of second signal lines connected to a first signal line to which a first capacitance is connected;
   a second capacitance connected to each of the plurality of second signal lines; and
   a memory cell connected to each of the plurality of second signal lines, the method comprising:
      supplying a charge corresponding to a signal value to be stored in the memory cell to each of the second signal lines;
      storing the charge corresponding to the signal value to be stored in the memory cell in each of the second capacitances;
      capacitively dividing the charge stored between the first capacitance and the plurality of second capacitances; and
      obtaining a digital signal corresponding to the charge of the first signal line.
      The aspects of the present disclosure are not limited to the above-mentioned individual embodiments, but also include various modifications that a person skilled in the art may conceive, and the effects of the present disclosure are not limited to the above-mentioned contents. In other words, various additions, modifications, and partial deletions are possible within the scope of the conceptual idea and intent of the present disclosure derived from the contents defined in the claims and their equivalents.

## Claims

1. An arithmetic device comprising:
a first signal line;
a first capacitance connected to the first signal line;
at least one subarray connected to the first signal line; and
a readout circuit that generates a digital signal according to a charge of the first signal line,
wherein
the subarray includes:
a second signal line connected to the first signal line via a first switching element;
a second capacitance connected to the second signal line; and
at least one memory cell connected to the second signal line and capable of supplying a charge corresponding to a signal value to be stored to the second signal line.

2. The arithmetic device according to claim 1, wherein
the first capacitance and the second capacitance are parasitic capacitances formed in a metal layer of a semiconductor element.

3. The arithmetic device according to claim 1, wherein
a plurality of the subarrays are connected to the first signal line, and
the second capacitance is different for each subarray.

4. The arithmetic device according to claim 1, wherein
a plurality of the subarrays are connected to the first signal line, and
the second capacitance is a variable capacitance.

5. The arithmetic device according to claim 4, wherein
the memory cell is connected to the second signal line via a second switching element to supply the charge corresponding to the signal value to the second signal line.

6. The arithmetic device according to claim 5, wherein
the second switching element is configured by a single switching element or by connecting a plurality of switching elements in series,
one end of the second switching element is connected to the second signal line,
the second switching element is turned on or off depending on the stored data,
a potential pulse signal is supplied from the other end of the second switching element, and
a charge corresponding to a potential and a pulse width of the potential pulse signal is stored in the second capacitance.

7. The arithmetic device according to claim 5, wherein
the subarray has a plurality of the memory cells, and
the memory cells are static random access memories (SRAMs) having the second switching elements.

8. The arithmetic device according to claim 7, wherein
the arithmetic device has:
a mode in which the second signal line and the plurality of memory cells are sequentially turned on at different timings,
a mode in which the second signal line and the plurality of memory cells are simultaneously turned on, and
a mode in which the second signal line and the plurality of memory cells are repeatedly turned on at different timings.

9. The arithmetic device according to claim 8, wherein
when the plurality of subarrays are used as memories, the variable capacitances of each of the plurality of the subarrays have the same capacitance, and
when the plurality of subarrays are used as arithmetic units, the variable capacitances of each of the plurality of the subarrays are changeable according to a rate of data addition.

10. The arithmetic device according to claim 9, wherein
among the plurality of subarrays, a subarray to be used as an arithmetic unit and a subarray to be used as a memory are configured to be able to be switched.

11. The arithmetic device according to claim 9, further comprising:
a first control unit that controls the first switching element and the second switching element; and
a second control unit that controls a potential of the second signal line when data is written to the memory cell.

12. The arithmetic device according to claim 5, wherein
the subarray has a plurality of the memory cells, and
the memory cell is composed of the second switching element and a flip-flop.

13. The arithmetic device according to claim 1, wherein
the second signal line is connected to the first signal line via the first switching element and a first resistor.

14. The arithmetic device according to claim 5, wherein
the memory cell is connected to the second signal line via the second switching element and a second resistor.

15. The arithmetic device according to claim 5, wherein
either the first switching element or the second switching element has a predetermined resistance value.

16. The arithmetic device according to claim 5, further comprising:
a first control unit that controls the first switching element and the second switching element;
a second control unit that controls a potential of the second signal line when data is written to the memory cell; and
an array unit, wherein
the array unit has a plurality of subarray units arranged in a matrix,
the subarray unit has a plurality of subarrays connected in a column to the first signal line,
the first control unit is arranged at both ends of one of the array units, and
the second control unit is arranged at both ends of the other of the array units.

17. The arithmetic device according to claim 16, wherein
a plurality of the subarray units share the readout circuit.

18. The arithmetic device according to claim 16, comprising:
a plurality of the readout circuits, wherein
at least one of the plurality of readout circuits is arranged at one end of the array unit, and
at least one of the plurality of readout circuits is arranged at the other end of the array unit.

19. An imaging device comprising:
the arithmetic device according to claim 1; and
a pixel array unit in which pixels that generate pixel signals obtained by photoelectrically converting incident light are arranged two-dimensionally, wherein
image data obtained by converting the pixel signals into digital data is stored in the memory cells of the arithmetic device.

20. A computing method for an arithmetic device, the arithmetic device including:
a plurality of second signal lines connected to a first signal line to which a first capacitance is connected;
a second capacitance connected to each of the plurality of second signal lines; and
a memory cell connected to each of the plurality of second signal lines, the method comprising:
supplying a charge corresponding to a signal value to be stored in the memory cell to each of the second signal lines;
storing the charge corresponding to the signal value to be stored in the memory cell in each of the second capacitances;
capacitively dividing the charge stored between the first capacitance and the plurality of second capacitances; and
obtaining a digital signal corresponding to the charge of the first signal line.
